# EUROPÄISCHE PATENTANMELDUNG

(11) **EP 4 803 477 A1**
(43) Veröffentlichungstag der Anmeldung: **09.09.2026**
(21) Anmeldenummer: 26162151.0
(22) Anmeldetag: 04.03.2026
(51) Int. Cl.: B81B 3/00, B81C 1/00

(54) **VERFAHREN ZUM HERSTELLEN EINES MIKROSTRUKTURELEMENTS UND MIKROSTRUKTURELEMENT**

(30) Priorität: 05.03.2025 DE 102025108367
(71) Anmelder: Fraunhofer-Gesellschaft zur Förderung der angewandten Forschung e.V., 80686 München (DE)
(72) Erfinder: LISEC, Thomas, 25524 Itzehoe (DE); CLAUSEN, Niels, 25524 Itzehoe (DE); GOJDKA, Björn, 25524 Itzehoe (DE); JENSEN, Björn, 25524 Itzehoe (DE); DANKWORT, Torben, 25524 Itzehoe (DE); KLINGBEIL, Finn, 25524 Itzehoe (DE)
(74) Vertreter: Hersina, Günter

(57) **Zusammenfassung**

Ein Verfahren 100 zum Herstellen eines Mikrostrukturelements umfasst folgende Schritte: Bereitstellen 110 eines Substrats, Anordnen 120 einer Vertiefungsstruktur in einem ersten Hauptoberflächenbereich des Substrats, Anordnen 130 einer Abdeckungsschicht auf dem ersten Hauptoberflächenbereich und in der Vertiefungsstruktur des Substrats, Aufbringen 140 einer Funktionsschicht auf der Abdeckungsschicht auf dem ersten Hauptoberflächenbereich und in der Vertiefungsstruktur des Substrats; Planarisieren 150 der Funktionsschicht, um einen planaren ersten Hauptoberflächenbereich der Funktionsschicht zu erhalten, wobei sich die Funktionsschicht an deren gegenüberliegenden zweiten Hauptoberflächenbereich entlang des Substrats und ferner in die Vertiefungsstruktur des Substrats erstreckt und in der Vertiefungsstruktur eine Verstärkungsstruktur bildet; und Freilegen 160 eines beweglichen Funktionsbereichs der Funktionsschicht durch bereichsweises Entfernen des Substrats unterhalb des beweglichen Funktionsbereichs, wobei die Verstärkungsstruktur zumindest teilweise in einem Verankerungsbereich der Funktionsschicht an dem Substrat angeordnet ist, und wobei die Funktionsschicht ohne Verstärkungsstruktur eine erste Dicke d1 und die Funktionsschicht mit der Verstärkungsstruktur eine größere zweite Dicke d2, mit d2 > d1, aufweist.

## Beschreibung

### Technisches Gebiet

Die vorliegende Erfindung bezieht sich auf ein Verfahren zur Herstellung eines Mikrostrukturelements und auf ein entsprechendes Mikrostrukturelement. Ausführungsbeispiele beziehen sich insbesondere auf ein Verfahren zur Herstellung mechanisch besonders belastbarer Mikrostrukturelemente, wie z. B. MEMS-Strukturen (MEMS = mikroelektromechanisches System).

### Technischer Hintergrund

Mikroelektromechanische Systeme (MEMS) werden aktuell im Allgemeinen auf einem Siliziumsubstrat mittels Prozessen der Halbleitertechnologie gefertigt. Ein Beispiel dafür sind Substrate mit einer Bauelementschicht (Device Layer) aus einkristallinem Silizium oder Polysilizium, wie sie in großer Stückzahl zur Herstellung der unterschiedlichen MEMS-Bauelemente genutzt werden. Die mechanischen Eigenschaften der beweglichen Mikrostrukturen werden durch die Dicke der Bauelementschicht bestimmt, die gemäß dem Stand der Technik über das gesamte Substrat konstant ist.

Ein wesentliches Problem mikroelektromechanischer (MEMS) Bauelemente mit freistehenden, beweglichen Mikrostrukturen, die auf dünnen Platten bzw. Funktionsschichten (Device Layer) aus Silizium oder Polysilizium basieren, ist deren mechanische Belastbarkeit. Je nach Material der belasteten Strukturen versagen MEMS-Bauelemente bei mechanischen Spannungen von etwa 100 MPa bis wenigen GPa (Pa = Pascal). Im Fall von Inertialsensoren, hergestellt mittels Techniken der Oberflächen-Mikromechanik, die in der Ebene angeregt und deren freistehende Mikrostrukturen dabei nur geringfügig ausgelenkt werden, kann eine hohe Empfindlichkeit bei ausreichend guter mechanischer Robustheit durch ein entsprechendes Design, z.B. in Form mechanischer Anschläge oder aktiver Rückstellmechanismen, gewährleistet werden. Bei anderen Bauelementen, wie z. B. Vibrations-Harvestern, Mikrospiegeln, Mikrofonen, Drucksensoren oder Lautsprechern, soll die bewegliche, freistehende Mikrostruktur hingegen anwendungsbedingt möglichst stark z.B. aus der Ebene ausgelenkt werden können. Eine hohe Empfindlichkeit und eine ausreichende mechanische Robustheit stehen hier im Widerspruch zueinander. So muss die bewegliche Mikrostruktur zumeist möglichst weich ausgelegt werden, um eine hinreichende Auslenkung für ein entsprechendes Ausgangssignal zu erzielen. Gleichzeitig muss ein MEMS-Bauelement je nach Anwendung mechanische Schocks bzw. Stöße von bis zu mehreren 1000 g (g = Erdbeschleunigung) unbeschadet überstehen können, wie z. B. 2900 g nach Standard JESd22-B110B. Neben externen Beschleunigungen durch Vibrationen, Stöße und Fallereignisse können Fluide (Gase oder Flüssigkeiten) Druckstöße auf die bewegliche Mikrostruktur ausüben, etwa im Fall von Mikrofonen oder Drucksensoren. Daher besteht ein großer Bedarf darin, die mechanische Robustheit von MEMS-Bauelementen zu erhöhen, ohne dabei aber den Herstellungsaufwand und damit die Kosten wesentlich zu vergrößern.

Hinsichtlich beispielhafter Veröffentlichungen zum Stand der Technik wird auf die Literaturliste am Ende der Beschreibung verwiesen.

Die der vorliegenden Erfindung zugrundeliegende Aufgabe besteht daher darin, ein verbessertes Verfahren zur Herstellung eines Mikrostrukturelements sowie ein verbessertes Mikrostrukturelement mit verbesserten mechanischen Eigenschaften, wie z. B. höherer mechanischer Belastbarkeit, bereitzustellen.

Diese Aufgabe wird durch den Gegenstand der unabhängigen Patentansprüche gelöst.

Spezifische Ausgestaltungen, Implementierungen und Weiterbildungen der vorliegenden Erfindung sind in den abhängigen Patentansprüchen definiert.

Gemäß einem Ausführungsbeispiel umfasst ein Verfahren zum Herstellen eines Mikrostrukturelements folgende Schritte:
Bereitstellen eines Substrats,
Anordnen (zumindest) einer Vertiefungsstruktur in einem ersten Hauptoberflächenbereich des Substrats,
Anordnen einer Abdeckungsschicht (BOX) auf dem ersten Hauptoberflächenbereich und in der Vertiefungsstruktur des Substrats,
Aufbringen einer Funktionsschicht auf der Abdeckungsschicht auf dem ersten Hauptoberflächenbereich und in der Vertiefungsstruktur des Substrats;
Planarisieren der Funktionsschicht, um einen planaren ersten Hauptoberflächenbereich der Funktionsschicht zu erhalten, wobei sich die Funktionsschicht an deren gegenüberliegenden zweiten Hauptoberflächenbereich entlang des Substrats und ferner in die Vertiefungsstruktur des Substrats erstreckt und in der Vertiefungsstruktur eine Verstärkungsstruktur bildet, und
Freilegen eines beweglichen Funktionsbereichs der Funktionsschicht zumindest durch bereichsweises Entfernen des Substrats (vertikal) unterhalb des beweglichen Funktionsbereichs, wobei die Verstärkungsstruktur zumindest teilweise in einem Verankerungsbereich der Funktionsschicht an dem Substrat angeordnet ist, und wobei die Funktionsschicht ohne Verstärkungsstruktur eine erste Dicke d1 und die Funktionsschicht mit der Verstärkungsstruktur eine größere zweite Dicke d2, mit d2 > d1, aufweist.

Die Funktionsschicht kann z.B. auch dort im Verankerungsbereich die erste Dicke d1 aufweisen, wo die Verstärkungsstruktur aufhört. Ferner kann die Verstärkungsstruktur auch teilweise in den beweglichen Funktionsbereich hineinragen. So weist die Funktionsschicht ohne (vorhandene) Verstärkungsstruktur in dem beweglichen Funktionsbereich eine erste Dicke d1 und in dem Verankerungsbereich mit (vorhandener) Verstärkungsstruktur (als Anker) eine größere zweite Dicke d2, mit d2 > d1, auf. Mit anderen Worten ausgedrückt heißt dies, dass die Funktionsschicht in dem Abschnitt des beweglichen Funktionsbereichs, in dem keine Verstärkungsstruktur vorhanden ist, eine erste Dicke d1 aufweist, und die Funktionsschicht in dem Abschnitt des Verankerungsbereichs, in dem die Verstärkungsstruktur vorhanden ist, eine größere zweite Dicke d2, mit d2 > d1, aufweist.

Gemäß einem Ausführungsbeispiel umfasst ein Mikrostrukturelement folgende Merkmale: ein mit einer Ausnehmung versehenes Substrat, und
einer Funktionsschicht, die mit einem beweglichen Funktionsbereich die Ausnehmung in dem Substrat überspannt und einen planaren ersten Hauptoberflächenbereich aufweist, wobei ein zweiter gegenüberliegender Hauptoberflächenbereich der Funktionsschicht an einem Randbereich mit dem Substrat gekoppelt ist, und wobei die Funktionsschicht an deren zweiten Hauptoberflächenbereich mindestens eine mit der Funktionsschicht direkt verbundene oder einstückig ausgebildete Verstärkungsstruktur aufweist,
wobei die mindestens eine Verstärkungsstruktur zumindest teilweise (teilweise oder vollständig) in einem Verankerungsbereich der Funktionsschicht an dem Substrat angeordnet ist, und wobei die Funktionsschicht ohne Verstärkungsstruktur eine erste (vertikale) Dicke d1 und die Funktionsschicht mit der Verstärkungsstruktur eine größere zweite Dicke d2, mit d2 > d1, aufweist.

Die erfindungsgemäße Vorgehensweise zur Verankerung der Funktionsschicht, d. h. des beweglichen Funktionsbereichs der Funktionsschicht, an dem Substrat ermöglicht eine robustere und belastbarere Ausgestaltung des Mikrostrukturelements (MEMS-Bauelements) gegenüber herkömmlichen MEMS-Bauelementen. Insbesondere kann entsprechend der erfindungsgemäßen Vorgehensweise die Verteilung des mechanischen Stresses und damit die mechanische Belastbarkeit beweglicher Mikrostrukturen, z. B. des beweglichen Funktionsbereichs der Funktionsschicht des Mikrostrukturelements, die beispielsweise aus einem Siliziummaterial hergestellt sind, verbessert werden. Dies wird insbesondere durch die erfindungsgemäße Verankerung der Funktionsschicht und damit des beweglichen Funktionsbereichs an dem zugeordneten Substrat erreicht. Die vorliegende Erfindung beschreibt nun ferner eine massenfertigungstaugliche Vorgehensweise, mit der die Verankerung der Funktionsschicht, die z. B. ein Siliziummaterial aufweist, an dem Substrat erreicht werden kann.

In der nachfolgenden Beschreibung werden noch unterschiedliche Ausführungs- und Anwendungsbeispiele für das erfindungsgemäße Verfahren zum Herstellen eines Mikrostrukturelements sowie für das erfindungsgemäße Mikrostrukturelement im Detail dargestellt.

### Kurzbeschreibung der Zeichnungen und Figuren:

Bevorzugte Ausführungsbeispiele der vorliegenden Erfindung werden nachfolgend unter Bezugnahme auf die beiliegenden Zeichnungen und Figuren näher erläutert. Es zeigen:
- Fig. 1: ein schematisches Flussdiagramm des erfindungsgemäßen Herstellungsverfahrens gemäß einem Ausführungsbeispiel;
- Fig. 2a-b: schematische Querschnittsansichten von beispielhaften Ausführungsformen des "hergestellten" Mikrostrukturelements mit dem erfindungsgemäßen Verankerungsbereich gemäß einem Ausführungsbeispiel;
- Fig. 3a: ein beispielhaftes prinzipielles Ablaufdiagramm des erfindungsgemäßen Herstellungsverfahrens gemäß einem Ausführungsbeispiel;
- Fig. 3b: ein beispielhaftes prinzipielles Ablaufdiagramm des erfindungsgemäßen Herstellungsverfahrens gemäß einem weiteren Ausführungsbeispiel;
- Fig. 4a-b: eine Gegenüberstellung einer schematischen Teilquerschnittsansicht (a) eines Verankerungsbereichs eines herkömmlichen MEMS-Bauelements gegenüber einer schematischen Teilquerschnittsansicht (b) einer beispielhaften Ausführungsform des Verankerungsbereichs des hergestellten Mikrostrukturelements gemäß einem Ausführungsbeispiel;
- Fig. 5a-c: (a) eine statische Simulation eines beispielhaften FEM-Modells (FEM = Finite-Elemente-Methode) des Mikrostrukturelements mit dem erfindungsgemäßen Verankerungsbereich, (b) eine beispielhafte Darstellung der Spannungsverteilung (erste Hauptspannung in N/m² unterhalb des Ankerbereichs, und (c) an der konkaven Kante im Material (z. B. Polysilizium) der Funktionsschicht im erfindungsgemäßen Verankerungsbereich;
- Fig. 6: eine grafische Darstellung des Verlaufs der maximalen mechanischen Spannung in der Verankerung des FEM-Modells in Abhängigkeit von dem Rundungsradius der konkaven Kante in dem Material (z. B. Polysilizium) der Funktionsschicht in dem Verankerungsbereich;
- Fig. 7: ein beispielhaftes prinzipielles Ablaufdiagramm des erfindungsgemäßen Herstellungsverfahrens gemäß einem weiteren Ausführungsbeispiel;
- Fig. 8: eine grafische Darstellung der maximalen mechanischen Spannung in der Abdeckungsschicht (vergrabenes Oxid = BOX) unterhalb des Ankerbereichs für zwei unterschiedliche Dicken des beweglichen Funktionsbereichs in Abhängigkeit von der Dicke des Ankerbereichs (für das FEM-Modell von Fig. 5a-c);
- Fig. 9: eine grafische Darstellung der maximalen mechanischen Spannung an der konkaven Kante in dem Material (z. B. Polysiliziummaterial) des erfindungsgemäßen Verankerungsbereichs für zwei Plattendicken des beweglichen Funktionsbereichs in Abhängigkeit von der Dicke des Ankerbereichs;
- Fig. 10a-b: eine Gegenüberstellung einer schematischen Teilquerschnittsansicht (a) eines Verankerungsbereichs eines herkömmlichen MEMS-Bauelements gegenüber einer schematischen Teilquerschnittsansicht (b) einer beispielhaf- ten Ausführungsform des "hergestellten" Mikrostrukturelements mit dem erfindungsgemäßen Verankerungsbereich gemäß einem weiteren Ausführungsbeispiel;
- Fig. 11a-c: (a) eine statische Simulation eines beispielhaften FEM-Modells des Mikrostrukturelements mit dem erfindungsgemäßen Verankerungsbereich, (b) eine beispielhafte Darstellung der Spannungsverteilung (erste Hauptspannung in N/m² unterhalb des Ankerbereichs, und (c) an der konkaven Kante im Material (z. B. Polysilizium) der Funktionsschicht im erfindungsgemäßen Verankerungsbereich (aber im Unterschied zu Fig. 5ac mit einem "Undercut" ΔL unterhalb des erfindungsgemäßen Verankerungsbereichs und einem Rundungsradius (von 0,5 µm) der konkaven Kante;
- Fig. 12: ein beispielhaftes prinzipielles Ablaufdiagramm des erfindungsgemäßen Herstellungsverfahrens gemäß einem weiteren Ausführungsbeispiel;
- Fig. 13a-c: eine (a) schematische und (b) vergrößerte Darstellung der erfindungsgemäßen Verankerung mit einem gitterförmigen Ankerbereich sowie (c) der resultierenden Spannungsverteilung unterhalb des Ankerbereichs und der Spannungsverteilung an einer konkaven Kante im Material (z. B. Polysilizium) der Funktionsschicht; und
- Fig. 14a-c: eine beispielhafte Darstellung der Oberflächenbeschaffenheit von Seitenwänden einer Vertiefung nach einem DRIE-Prozess (DRIE = Deep Reactive Ion Etching); und
- Fig. 15a-c: eine beispielhafte, schematische Darstellung der Strukturierung einer Poly-Silizium-Schicht mittels eines DRIE-Prozesses (DRIE = Deep Reactive Ion Etching) und der resultierenden Oberflächenbeschaffenheit der Seitenwände der erhaltenen Struktur (Cantilever).

Bevor nachfolgend Ausführungsbeispiele der vorliegenden Erfindung im Detail anhand der Zeichnungen und Figuren näher erläutert werden, wird darauf hingewiesen, dass identische, funktionsgleiche oder gleichwirkende Elemente, Objekte, Funktionsblöcke und/oder Verfahrensschritte in den unterschiedlichen Figuren mit gleichen Bezeichnungen und/oder Bezugszeichen versehen sind, so dass die in unterschiedlichen Ausführungsbeispielen dargestellte Beschreibung dieser Elemente, Objekte, Funktionsblöcke und/oder Verfahrensschritte (mit gleichen Bezeichnungen und/oder Bezugszeichen) untereinander austauschbar ist bzw. aufeinander angewendet werden kann.

### Detaillierte Beschreibung der Figuren und Ausführungsbeispiele

In der nachfolgenden Beschreibung bedeutet die Beschreibung einer Halbleiterschicht, dass die Halbleiterschicht ein Halbleitermaterial aufweist, d.h. zumindest teilweise oder auch vollständig aus dem Halbleitermaterial gebildet ist.

Es versteht sich, dass, wenn ein Element als mit einem anderen Element "verbunden" oder "gekoppelt" bezeichnet wird, es direkt mit dem anderen Element verbunden oder gekoppelt sein kann oder ein oder mehrere Zwischenelemente vorhanden sein können. Wenn im Gegensatz ein Element als "direkt" mit einem anderen Element "verbunden" oder "gekoppelt" bezeichnet wird, sind keine Zwischenelemente vorhanden. Sonstige zum Beschreiben des Verhältnisses zwischen Elementen benutzten Ausdrücke sollten auf gleichartige Weise ausgelegt werden (z.B. "zwischen" gegenüber "direkt zwischen", "benachbart" gegenüber "direkt benachbart" usw.).

Zur Vereinfachung der Beschreibung der unterschiedlichen Ausführungsbeispiele weisen zumindest einige der Figuren ein kartesisches Koordinatensystem x, y, z auf, wobei die Richtungen x, y, z orthogonal zueinander angeordnet sind. Bei den Ausführungsbeispielen entspricht die x-y-Ebene dem (oberen) Hauptoberflächenbereich eines Trägers bzw. Substrats (= Referenzebene = x-y-Ebene), wobei die dazu vertikale Richtung nach oben bezüglich der Referenzebene (x-y-Ebene) der "+z"-Richtung entspricht, und wobei die Richtung vertikal nach unten bezüglich der Referenzebene (x-y-Ebene) der "-z"-Richtung entspricht. In der folgenden Beschreibung bedeutet der Ausdruck "lateral" eine Richtung parallel zu der x- und/oder y-Richtung, d. h. parallel zu der x-y-Ebene, wobei der Ausdruck "vertikal" eine Richtung parallel zu der +/- z-Richtung angibt.

In der folgenden Beschreibung gibt eine Dicke oder Höhe eines Elements üblicherweise eine vertikale Abmessung dieses Elements an, während eine Breite oder Länge eines Elements üblicherweise eine laterale Abmessung dieses Elements angibt. In den Figuren sind die unterschiedlichen Elemente nicht notwendigerweise maßstäblich gezeichnet. Daher können die lateralen und vertikalen Abmessungen der beschriebenen Elemente, z. B. die Dicken und Breiten der einzelnen Halbleiterschichten, Isolationsschichten, des Halbleitersubstrats etc. nicht maßstäblich gezeichnet sein.

Im Rahmen der vorliegenden Beschreibung sind in Klammern gesetzte Begriffe und/oder Textpassagen als weitere alternative Bezeichnungen oder beispielhafte Erläuterungen, Ausgestaltungen, Ergänzungen bzw. Alternativen (zu dem zugehörigen Begriff oder der zugehörigen Textpassage) zu verstehen.

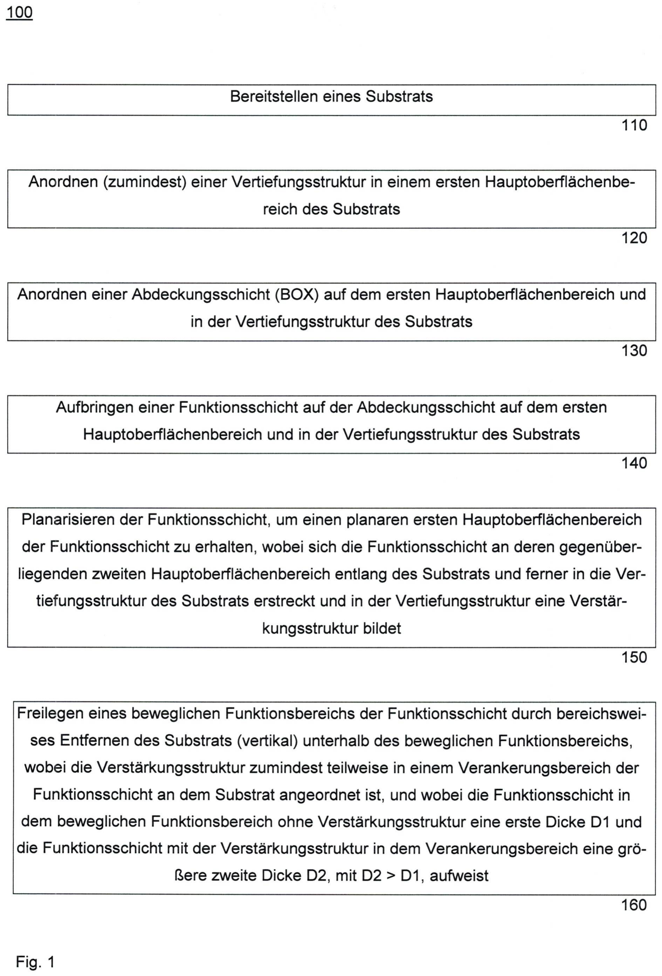

Fig. 1 zeigt nun ein schematisches Flussdiagramm des erfindungsgemäßen Herstellungsverfahrens 100 eines Mikrostrukturelements 10 gemäß einem Ausführungsbeispiel.

Bei dem Verfahren 100 zum Herstellen eines Mikrostrukturelements 10 wird zunächst bei Schritt 110 ein Substrat bereitgestellt. Bei Schritt 120 wird (zumindest) eine Vertiefungsstruktur in einem ersten Hauptoberflächenbereich des Substrats angeordnet. Bei Schritt 130 wird eine Abdeckungsschicht, z. B. in Form eines vergrabenen Oxids (BOX = Buried Oxide), auf dem ersten Hauptoberflächenbereich und in der Vertiefungsstruktur des Substrats angeordnet. Bei Schritt 140 wird ferner eine Funktionsschicht auf der Abdeckungsschicht auf dem ersten Hauptoberflächenbereich und in der Vertiefungsstruktur des Substrats aufgebracht. Bei Schritt 150 wird die Funktionsschicht planarisiert, um einen planaren ersten Hauptoberflächenbereich der Funktionsschicht zu erhalten, wobei sich die Funktionsschicht an deren gegenüberliegenden zweiten Hauptoberflächenbereich entlang des Substrats und ferner in die Vertiefungsstruktur des Substrats erstreckt und in der Vertiefungsstruktur eine Verstärkungsstruktur bildet. Bei Schritt 160 wird ein beweglichen Funktionsbereichs der Funktionsschicht zumindest durch bereichsweises Entfernen des Substrats (vertikal) unterhalb des beweglichen Funktionsbereichs freigelegt, d.h. das Substrat wird bereichsweise (vertikal) unterhalb eines beweglichen Funktionsbereichs entfernt und der beweglicher Funktionsbereich der Funktionsschicht freigelegt.

Bei Schritt 160 kann gemäß einem Ausführungsbeispiel der bewegliche Funktionsbereich der Funktionsschicht durch bereichsweises Entfernen des Substrats, z.B. vertikal, unterhalb des beweglichen Funktionsbereichs freigelegt werden. Dies ist beispielsweise der Fall, falls der bewegliche Funktionsbereich als eine umlaufend befestigte, auslenkbare Membran ausgebildet wird. Gemäß einem weiteren Ausführungsbeispiel kann bei dem Herstellungsschritt 160 ferner auch bereichsweise die Funktionsschicht z.B. mittels eines Vorderseitenprozesses in der Ebene strukturiert werden, um den beweglichen Funktionsbereich z.B. als ein auslenkbares Balkenelement zu erhalten. Die Funktionsschicht kann also zum Freilegen des beweglichen Funktionsbereichs (z.B. als auslenkbares Balkenelement) bereichsweise entfernt werden.

Die Verstärkungsstruktur ist nun zumindest teilweise, d. h. teilweise oder vollständig, in einem Verankerungsbereich der Funktionsschicht an dem Substrat angeordnet, wobei die Funktionsschicht ohne Verstärkungsstruktur eine erste Dicke d1 und die Funktionsschicht mit der Verstärkungsstruktur eine größere zweite Dicke d2, mit d2 > d1, aufweist.

Die Funktionsschicht kann z.B. auch dort im Verankerungsbereich die erste Dicke d1 aufweisen, wo die Verstärkungsstruktur aufhört. Ferner kann die Verstärkungsstruktur auch teilweise in den beweglichen Funktionsbereich hineinragen. So weist die Funktionsschicht ohne (vorhandene) Verstärkungsstruktur in dem beweglichen Funktionsbereich eine erste Dicke d1 und in dem Verankerungsbereich mit (vorhandener) Verstärkungsstruktur (als Anker) eine größere zweite Dicke d2, mit d2 > d1, auf. Mit anderen Worten ausgedrückt heißt dies, dass die Funktionsschicht in dem Abschnitt des beweglichen Funktionsbereichs, in dem keine Verstärkungsstruktur vorhanden ist, eine erste Dicke d1 aufweist, und die Funktionsschicht in dem Abschnitt des Verankerungsbereichs, in dem die Verstärkungsstruktur vorhanden ist, eine größere zweite Dicke d2, mit d2 > d1, aufweist.

Gemäß einem Ausführungsbeispiel kann die Vertiefungsstruktur mit einer solchen Tiefe in dem Substrat angeordnet und die Funktionsschicht mit einer solchen Dicke auf das Substrat aufgebracht werden, dass nach dem Planarisieren (bei Schritt 150) die Verstärkungsstruktur der Funktionsschicht eine größere zweite Dicke d2, mit d2 ≥ 2*d1, aufweist. So kann die Vertiefungsstruktur mit einer solchen Tiefe in dem Substrat angeordnet und die Funktionsschicht mit einer solchen Dicke auf das Substrat aufgebracht wird, dass nach dem Planarisieren die erste Dicke d1 der Funktionsschicht zwischen 2 und 125 µm oder zwischen 3 und 80 µm und die zweite Dicke d2 der Verstärkungsstruktur, mit d2 ≥ 2*d1, zwischen 4 und 250 µm oder zwischen 6 und 160 µm beträgt.

Bei dem Schritt 140 des Aufbringens einer Funktionsschicht kann eine Materialschicht, die beispielsweise Polysilizium, einkristallines Silizium oder auch andere Materialien, wie z.B. Metallen oder Dielektrika, aufweist oder daraus besteht, aufgebracht werden. Die möglichen Dicken des aufgebrachten Materials der Funktionsschicht werden dabei durch die verfügbaren Abscheide- bzw. Aufbringungsprozesse definiert.

Die Funktionsschicht kann beispielweise auch zumindest teilweise (oder vollständig) als ein Stapel aus zwei oder mehr Schichten desselben Materials oder aus unterschiedlichen Materialien aufgebracht werden. Dabei kann eine zusätzliche Schicht für die (resultierende) Funktionsschicht bzw. den Funktionsschichtstapel z. B. nach dem Planarisieren (Schritt 150 des Herstellungsverfahrens 100) aufgebracht werden. Ferner können einzelne oder alle Schichten der Funktionsschicht planarisiert werden oder der Funktionsschichtstapel abschließend bei Schritt 150 planarisiert werden. Durch die Ausgestaltung der Funktionsschicht als Schichtstapel lassen sich deren mechanische Eigenschaften in einem erweiterten Bereich einstellen bzw. erhöhen. Somit eröffnet ein Schichtstapel zusätzliche Freiheitsgrade zur Einstellung der mechanischen Eigenschaften des beweglichen Funktionsbereichs der Funktionsschicht.

Bei dem Ätzprozess von Schritt 160, bei dem der bewegliche Funktionsbereich der Funktionsschicht freigelegt wird, kann die Abdeckungsschicht beispielsweise als Ätzstoppschicht für den Ätzvorgang dienen. Gemäß einem Ausführungsbeispiel kann bei dem Schritt 160 des Freilegens eines beweglichen Funktionsbereichs der Funktionsschicht ferner die Abdeckungsschicht, z. B. vertikal, unterhalb des beweglichen Funktionsbereichs, zumindest bereichsweise, d. h. bereichsweise oder vollständig, entfernt werden. Alternativ kann die Abdeckungsschicht an dem beweglichen Funktionsbereich der Funktionsschicht auch verbleiben und (falls erforderlich) beispielsweise eine Schutzfunktion für den beweglichen Funktionsbereich z.B. gegenüber störenden Umgebungseinflüssen übernehmen.

Bezüglich der vorliegenden Beschreibung von Ausführungsbeispielen des erfindungsgemäßen Herstellungsverfahrens wird darauf hingewiesen, dass der bewegliche Funktionsbereich des Mikrostrukturelements in der Ebene (bzw. lateral) eine im Wesentlichen beliebige Ausgestaltung und Form aufweisen kann. Dafür kann die Funktionsschicht vor oder nach dem Freilegen in Schritt 160 strukturiert werden. Zur Strukturierung der Funktionsschicht kann je nach Material ein geeigneter Prozess verwendet werden. Wird beispielsweise Polysilizium für die Funktionsschicht verwendet, kann die Strukturierung z.B. mittels DRIE erfolgen. So kann beispielsweise nach Aufbringen einer lithographischen Maske (Fotolithographie) ein Ätzvorgang von der Oberseite (Vorderseite) der Funktionsschicht, z.B. mittels DRIE, durchgeführt werden.

Gemäß einem Ausführungsbeispiel kann die Verstärkungsstruktur als ein einteiliges bzw. einstückiges, z. B. balkenförmiges, Verstärkungselement an dem zweiten Hauptoberflächenbereich der Funktionsschicht angeordnet werden.

Gemäß einem Ausführungsbeispiel kann die Verstärkungsstruktur mit einer Mehrzahl von Verstärkungselementen an dem zweiten Hauptoberflächenbereich der Funktionsschicht angeordnet werden, d. h. die Verstärkungsstruktur kann eine Mehrzahl von Verstärkungselementen an dem zweiten Hauptoberflächenbereich der Funktionsschicht aufweisen. So können beispielsweise die Verstärkungselemente benachbart angeordnet und/oder miteinander, z. B. gitterförmig, verbunden sein, wobei die Verstärkungselemente z. B. länglich, lamellenförmig, rippenförmig, wabenförmig, gitterförmig, elliptisch, kreisförmig, oder wellen- oder bogenförmig etc. an dem zweiten Hauptoberflächenbereich der Funktionsschicht angeordnet sein können. Die Ausgestaltung der Verstärkungselemente der Verstärkungsstruktur kann beispielsweise von der Form des beweglichen Funktionsbereichs, von der Verankerung des beweglichen Funktionsbereichs an dem Substrat und/oder der gewünschten lokalen Steifigkeit der Funktionsschicht bzw. des beweglichen Funktionsbereichs der Funktionsschicht abhängen.

Bei Verstärkungsstrukturen mit einer Mehrzahl von Verstärkungselementen sollten entlang der Übergangskanten von Bereichen mit der größeren Dicke d2 in bewegliche Funktionsbereiche mit der geringeren Dicke d1 Verstärkungselemente, z.B. in Form eines Gitters, bereitgestellt werden.

Gemäß einem Ausführungsbeispiel können die Vertiefungselemente der Vertiefungsstruktur mit einer maximalen Breite (Vertiefungsbreite) in dem ersten Hauptoberflächenbereich des Substrats angeordnet werden, wobei die Funktionsschicht mit einer Schichtdicke aufgebracht wird, die zumindest der halben maximalen Breite der Vertiefungselemente entspricht. Somit kann die maximale Breite der einzelnen Vertiefungselemente weniger als die halbe Dicke der Funktionsschicht betragen, wobei die Vertiefungselemente aber unter Berücksichtigung dieser Randbedingung auch unterschiedliche Breiten zueinander aufweisen können.

Gemäß einem Ausführungsbeispiel kann die Vertiefungsstruktur an einer solchen Position in dem Substrat angeordnet werden, dass die (dann erhaltene) Verstärkungsstruktur an dem zweiten Hauptoberflächenbereich der Funktionsschicht an dem Einspannbereich (Verankerungsbereich) der Funktionsschicht angeordnet ist oder sich von dem Einspannbereich der Funktionsschicht in den beweglichen Funktionsbereich der Funktionsschicht erstreckt.

Gemäß einem weiteren Ausführungsbeispiel kann optional eine weitere Vertiefungsstruktur an einer solchen Position in dem Substrat angeordnet werden, dass die (dann erhaltene) Verstärkungsstruktur vollständig an dem freigelegten zweiten Hauptoberflächenbereich des beweglichen Funktionsbereichs des Funktionselements angeordnet wird. Somit kann die Verstärkungsstruktur inselförmig an dem beweglichen Funktionsbereich des Funktionselements vorgesehen werden, um eine lokale Modifikation der Steifigkeit bzw. Verstärkung des beweglichen Funktionsbereichs zu erhalten.

Im Nachfolgenden werden einige Beispiele für mögliche Ausgestaltungen des beweglichen Funktionsbereichs dargestellt, die beispielsweise mit dem erfindungsgemäßen Herstellungsverfahren 100 erhalten werden können. So kann insbesondere der Herstellungsschritt 160 jeweils ausgeführt werden, um eine der nachfolgend dargestellten Ausgestaltungen (Ausführungsformen) des beweglichen Funktionsbereichs der Funktionsschicht durch Strukturieren der Funktionsschicht in der Ebene und bereichsweises Entfernen des Substrats, z.B. vertikal, unterhalb des beweglichen Funktionsbereichs freizulegen.

So kann der bewegliche Funktionsbereich als ein Balkenelement (Cantilever, Biegebalken oder auslenkbare Platte) einseitig eingespannt sein, wobei die Verstärkungsstruktur beispielsweise am Einspannbereich (Verankerungsbereich) mit dem Substrat und eine (optionale) weitere Verstärkungsstruktur auch im freiliegenden Balkenbereich vorgesehen sein kann. Bei einer Ausgestaltung als Biegebalken (oder Biegeplatte) mit Masseelement (träge Masse) kann an dem Verankerungsbereich des Masseelements mit dem Balkenelement beispielsweise auch eine (zusätzliche) Verstärkungsstruktur vorgesehen sein, wobei im Falle von mehreren Verstärkungsstrukturen diese eine gleiche Dicke aufweisen können oder basierend auf der unterschiedlichen Position auch unterschiedliche Dicken aufweisen können. Um den beweglichen Funktionsbereich als ein auslenkbares Balkenelement zu erhalten, kann bei dem Herstellungsschritt 160 ferner auch bereichsweise die Funktionsschicht z.B. mittels eines Vorderseitenprozesses, in der Ebene strukturiert werden, d.h. zum Freilegen des beweglichen Funktionsbereichs (als auslenkbares Balkenelement) stellenweise entfernt werden.

Gemäß einer weiteren Ausführungsform kann der bewegliche Funktionsbereich beispielsweise auch als eine umlaufend befestigte, auslenkbare Membran ausgebildet sein, die optional auch ein Masseelement in dem beweglichen Funktionsbereich aufweist. So kann beispielsweise der umlaufende Verankerungsbereich eine entsprechende, umlaufende Verstärkungsstruktur um den beweglichen Funktionsbereich aufweisen. Gemäß einem Ausführungsbeispiel kann sich die (umlaufende) Verstärkungsstruktur beispielsweise teilweise in den beweglichen Funktionsbereich erstrecken. Um den beweglichen Funktionsbereich als eine umlaufend befestigte, auslenkbare Membran zu erhalten bzw. freizulegen, ist bei dem Herstellungsschritt 160 beispielweise kein Vorderseitenätzprozess an der Funktionsschicht erforderlich.

Ferner kann bei einer umlaufend befestigten, auslenkbaren Membran als beweglicher Funktionsbereich die Verstärkungsstruktur auch nur bereichsweise oder abschnittsweise (z.B. gleichmäßig beabstandet bzw. symmetrisch) an dem umlaufenden Verankerungsbereich der Funktionsschicht angeordnet sein. Falls es entlang der Einspannung einer umlaufend befestigten Membran Abschnitte oder Bereiche gibt, in denen die Entstehung hoher mechanischer Spannungen ausgeschlossen ist, braucht an diesen Stellen keine Verstärkungsstruktur vorgesehen werden. Die Verstärkungselemente sollten jedoch ausreichend dicht angeordnet sein, so dass sie sich gegenseitig "stützen", d.h. es in den dazwischen liegenden Bereichen nicht zu hohen bzw. übermäßigen mechanischen Spannungen kommen kann.

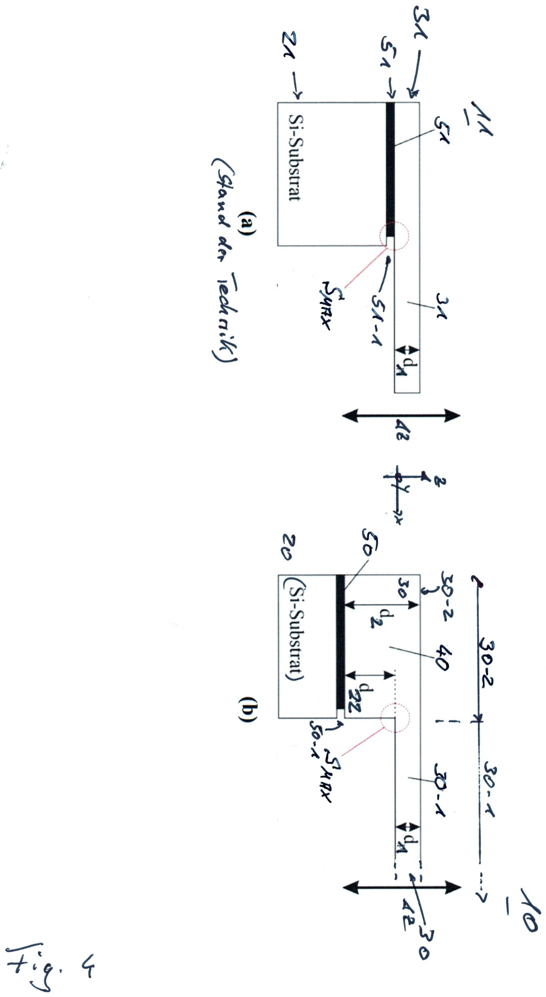

Gemäß einer weiteren beispielhaften Ausführungsform kann der bewegliche Funktionsbereich auch als eine abschnittsweise befestigte, auslenkbare Membran ausgebildet sein, die optional auch ein Masseelement in dem beweglichen Funktionsbereich aufweist. Der Einspannbereich kann somit in mehrere Abschnitte entlang des Umfangs der Membran unterteilt sein. Diese Abschnitte können beispielsweise gleichmäßig (symmetrisch) um den beweglichen Funktionsbereich verteilt angeordnet sein. Wie bereits oben angegeben wurde, können eine oder mehrere Verstärkungsstrukturen an den Einspannbereichen (Verankerungsbereichen) der Funktionsschicht und optional auch an dem beweglichen Funktionsbereich angeordnet sein. In einem Abschnitt können beispielsweise mehrere Verstärkungsstrukturen angeordnet werden, falls in den dazwischen befindlichen Bereichen (gemäß Fig. 4a) keine zu hohen mechanischen Spannungen an kritischen Stelle, z.B. in der Abdeckungsschicht (BOX) 50, entstehen.

Die oben beschriebenen, unterschiedlichen Verstärkungsstrukturen an dem Verankerungsbereich bzw. den Verankerungsbereichen und optional an dem beweglichen Funktionsbereich können gleich dimensioniert sein oder aber auch unterschiedliche Dicken und unterschiedliche laterale Abmessungen aufweisen.

Im Folgenden wird bei dem Verfahren 100 das Anordnen eines starren Elements, wie z. B. eines Masseelements bzw. Träge-Masse-Element, an dem beweglichen Funktionsbereich der Funktionsschicht beispielhaft dargestellt. So kann bei Schritt 120 des Anordnens eine weitere Vertiefungsstruktur in dem ersten Hauptoberflächenbereich des Substrats vorgesehen werden. Bei Schritt 130 wird ferner die Abdeckungsschicht in der weiteren Vertiefungsstruktur des Substrats angeordnet. Ferner wird bei Schritt 140 die Funktionsschicht auf der Abdeckungsschicht auch in der weiteren Vertiefungsstruktur des Substrats aufgebracht und anschließend planarisiert (Schritt 150). Bei dem Schritt 160 des Freilegens des beweglichen Funktionsbereichs der Funktionsschicht kann ferner bei der Rückseitenöffnung des Substrats an dem beweglichen Funktionsbereich oder innerhalb des beweglichen Funktionsbereichs der Funktionsschicht ein starres Element, wie z. B. ein Masseelement (Träge-Masse-Element), gebildet werden. Um den beweglichen Funktionsbereich als ein auslenkbares Balkenelement zu erhalten, kann bei dem Herstellungsschritt 160 ferner auch bereichsweise die Funktionsschicht z.B. mittels eines Vorderseitenprozesses, in der Ebene strukturiert werden, d.h. zum Freilegen des beweglichen Funktionsbereichs (als auslenkbares Balkenelement) stellenweise entfernt werden.

Das Masseelement weist beispielsweise einen freigelegten Materialbereich des Substrats auf. Die weitere Verstärkungsstruktur ist zumindest teilweise in dem (weiteren) Verankerungsbereich des Masseelements an der Funktionsschicht angeordnet. Das Masseelement wird somit an dem beweglichen Funktionsbereich der Funktionsschicht auslenkbar getragen. Die weitere Verstärkungsstruktur der Funktionsschicht weist beispielsweise die zweite Dicke d2, mit d2 > d1 oder d2 ≥ 2*d1, wobei die weitere Verstärkungsstruktur auch eine weitere Dicke d3, mit d3 > d1 oder d3 ≥ 2*d1 aufweisen kann, wobei d3 ≠ d2 ist. Somit können die Verstärkungsstruktur (der Anker) des beweglichen Funktionsbereichs an dem Substrat und die weitere Verstärkungsstruktur (Anker) an dem Masseelement gleiche oder auch unterschiedliche Dicken aufweisen, aber jeweils zumindest eine Dicke > d1.

Gemäß einem Ausführungsbeispiel kann die weitere Vertiefungsstruktur mit einer solchen Tiefe in dem Substrat angeordnet und die Funktionsschicht mit einer solchen Dicke auf das Substrat aufgebracht werden, dass nach dem Planarisieren (bei Schritt 150) die weitere Verstärkungsstruktur der Funktionsschicht eine größere dritte Dicke d3, mit d3 ≥ 2*d1, aufweist, und die erste Dicke d1 der Funktionsschicht zwischen 2 und 125 µm oder zwischen 3 und 80 µm und die dritte Dicke d3 der weiteren Verstärkungsstruktur, mit d3 ≥ 2*d1, zwischen 4 und 250 µm oder zwischen 6 und 160 µm beträgt.

Gemäß einem Ausführungsbeispiel kann die bewegliche Mikrostruktur (der bewegliche Funktionsbereich) der Funktionsschicht auch an mehreren Positionen am Substrat verankert sein, so dass das Masseelement an mehreren flexiblen Platten bzw. Balken aufgehängt ist. Ferner kann der bewegliche Funktionsbereich der Funktionsschicht in der lateralen Ebene eine beliebige Form aufweisen und kann an mehreren Stellen oder auch umlaufend verankert sein.

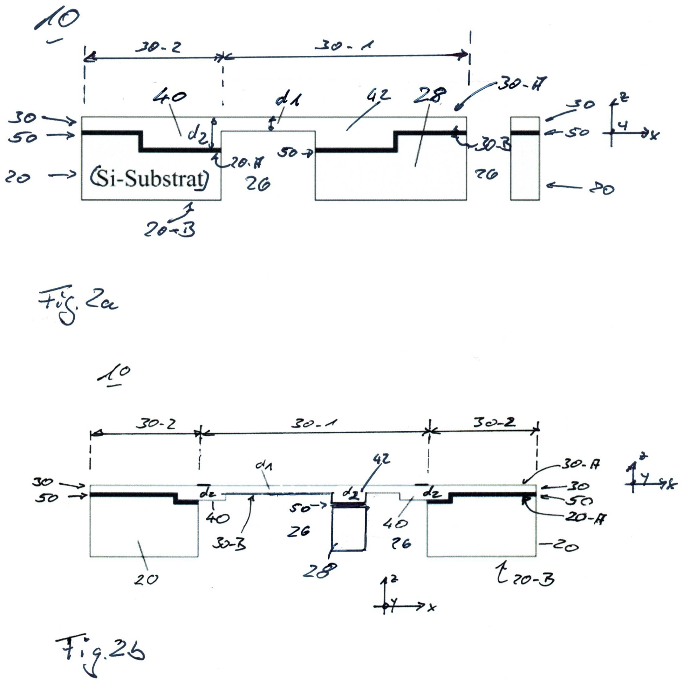

Gemäß einem Ausführungsbeispiel kann bei dem Schritt 160 des Freilegens des beweglichen Funktionsbereichs auch bereichsweise (z.B. mittels eines Vorderseitenätzprozesses) die Funktionsschicht so entfernt werden, um den beweglichen, auslenkbaren Funktionsbereich als einen auslenkbaren Arm oder eine auslenkbare Platte, z.B. für ein Masseelement, zu erhalten. Mit Verweis auf die Querschnittsansicht von Fig. 2a ist dort in der Zeichenebene rechts eine durchgehende Ausnehmung (Rückseitenöffnung oder Durchgangsöffnung) 26 durch das Substrat 20, die Abdeckungsschicht 50 und die Funktionsschicht 30 dargestellt. Bei Schritt 160 kann die Rückseitenöffnung durch das Substrat 20 z.B. bei der Abdeckungsschicht 50 (falls diese als Ätzstoppschicht wirksam ist) enden, während bei einem Vorderseitenprozess die Funktionsschicht 30 und z.B. auch die Abdeckungsschicht 50 bereichsweise (oberhalb der Rückseitenöffnung) entfernt wird. Die Abdeckungsschicht 50 kann aber entweder mit einem Rückseitenprozess oder einem Vorderseitenprozess in der Ausnehmung 26 in dem Substrat 20 (bereichsweise) entfernet werden. So kann die Abdeckungsschicht (das Oxid) 50 in den Bereichen flächig entfernt werden, in denen vorher das Substrat 20 entfernt wurde. Das kann durch (anisotropes) RIE (von der Substratrückseite) erfolgen oder durch denselben (isotropen) Ätzprozess, mit dem der beweglichen Funktionsbereich, z.B. ein Inertialsensor, der Funktionsschicht 30 von der Vorderseite freigeätzt wird.

Gemäß einem weiteren Ausführungsbeispiel kann das Herstellungsverfahren 100 ferner einen Schritt 125 des Durchführens eines Verrundungsprozesses von Ecken- und/oder Kantenbereichen an dem ersten Hauptoberflächenbereich des mit der zumindest einen Vertiefung versehenen Substrats aufweisen, um an den (verrundeten) Ecken- und/oder Kantenbereichen Rundungsradien zwischen 0,5 µm und 9 µm oder zwischen 1 und 7 µm oder zwischen 1,5 µm und 5 µm zu erhalten. Gleichzeitig kann der Verrundungsprozess zu einer Glättung des ersten Hauptoberflächenbereichs des mit der zumindest einen Vertiefung versehenen Substrats führen, einschließlich der Oberflächen der Vertiefung.

Durch diese Verrundung von Kanten und Ecken an dem ersten Hauptoberflächenbereich des mit der zumindest einen Vertiefung versehenen Substrats können dann entsprechend verrundete (abgerundete) Ecken und Kanten an dem zweiten Hauptoberflächenbereich der Funktionsschicht und damit an der (dann erhaltenen) Verstärkungsstruktur erhalten werden. Durch diese Verrundungen (Abrundungen) der Funktionsschicht und insbesondere der Verstärkungsstruktur können maximale mechanische Spannungen in der (dann mit solchen Verrundungen versehenen) Funktionsschicht deutlich (gegenüber einem nicht-verrundeten Zustand) reduziert werden. Auf gleiche Weise führt eine Glättung des ersten Hauptoberflächenbereichs des Substrats dazu, dass die Oberflächen des zweiten Hauptoberflächenbereichs der Funktionsschicht glatter ausfallen. Das kann die Bruchfestigkeit der beweglichen Mikrostruktur beträchtlich steigern.

Gemäß einem Ausführungsbeispiel kann der Verrundungsprozess z.B. bei einem Schritt 125 von Ecken- und/oder Kantenbereichen an dem ersten Hauptoberflächenbereich des mit der zumindest einen Vertiefung versehenen Substrats mit einem Trockenätzprozess, Oxidationsprozess oder Temperungsprozess in Wasserstoff durchgeführt werden.

Gemäß einem Ausführungsbeispiel kann der Schritt 160 des Freilegens des beweglichen Funktionsbereichs der Funktionsschicht ausgehend von dem zweiten Hauptoberflächenbereich des Substrats mittels eines anisotropen Ätzprozesses durchgeführt werden, um eine Ausnehmung bzw. eine Rückseitenöffnung (Durchgangsöffnung) 26 durch das Substrat 20 zu erhalten. Ein solcher anisotroper Ätzprozess kann beispielsweise einen sogenannten Bosch-Prozess oder einen DRIE-Prozess (reaktives Ionentiefenätzen = Deep Reactive Ion Etching = DRIE) aufweisen, um die Ausnehmung in dem Substrat zu erhalten, wobei die Abdeckungsschicht beispielsweise als Ätzstoppschicht für den Ätzvorgang dienen kann.

Gemäß einem Ausführungsbeispiel kann das Substrat beispielsweise ein Siliziummaterial aufweisen, wobei die Funktionsschicht ein Poly-Si-Material und die Abdeckungsschicht ein Oxidmaterial, z.B. Siliziumoxid, aufweisen kann.

Gemäß einem Ausführungsbeispiel kann die Vertiefungsstruktur mit einer solchen Tiefe in dem Substrat angeordnet und die Funktionsschicht mit einer solchen Dicke auf das Substrat aufgebracht werden, dass die Funktionsschicht nach dem Schritt 150 des Planarisierens die erste Dicke von zumindest 2 µm oder zwischen 2 µm und 125 µm aufweist.

In Fig. 2a-b sind nun schematische Querschnittsansichten von beispielhaften Ausführungsformen des (hergestellten) Mikrostrukturelements 10 mit einer Verstärkungsstruktur 40 in dem Verankerungsbereich 30-2 der Funktionsschicht 30 gemäß einem Ausführungsbeispiel dargestellt.

Wie in Fig. 2a beispielhaft dargestellt ist, kann der bewegliche Funktionsbereich 30-1 der Funktionsschicht 30 als ein Balkenelement (Cantilever, Biegebalken oder auslenkbare Platte) ausgebildet und einseitig eingespannt sein.

Wie in Fig. 2B beispielhaft dargestellt ist, kann der bewegliche Funktionsbereich 30-1 der Funktionsschicht 30 beispielsweise auch als eine auslenkbare Membran ausgebildet sein, die umlaufend befestigt ist oder (entlang des Umfangs) abschnittsweise befestigt ist.

Gemäß dem Ausführungsbeispiel von Fig. 2a-b umfasst das Mikrostrukturelement 10 ein mit einer Ausnehmung 26 versehenes Substrat 20 und eine Funktionsschicht 30. Die Funktionsschicht 30 überspannt mit einem beweglichen Funktionsbereich 30-1 die Ausnehmung 26 in dem Substrat 20 und weist einen planaren (ebenen) ersten Hauptoberflächenbereich 30-A auf. Der zweite gegenüberliegende Hauptoberflächenbereich 30-B der Funktionsschicht 30 ist an einem Randbereich (Verankerungsbereich) 30-2 mit dem Substrat 20 gekoppelt bzw. an dem Substrat 20 verankert. Die Funktionsschicht 30 weist an deren zweiten Hauptoberflächenbereich 30-B zumindest eine mit der Funktionsschicht direkt verbundene oder einstückig ausgebildete Verstärkungsstruktur 40 auf. Die zumindest eine Verstärkungsstruktur 40 ist zumindest teilweise, d.h. teilweise oder vollständig, in einem Verankerungsbereich 30-2 der Funktionsschicht 30 (zur Verankerung der Funktionsschicht 30 an dem Substrat 20) angeordnet, wobei die Funktionsschicht 30 ohne Verstärkungsstruktur in dem beweglichen Funktionsbereich 30-1 eine erste (vertikale) Dicke d1 und die Funktionsschicht 30 mit der Verstärkungsstruktur 40 eine größere zweite Dicke d2, mit d2 > d1, aufweist. Gemäß einem Ausführungsbeispiel kann die Verstärkungsstruktur 40 der Funktionsschicht 30 in dem Verankerungsbereich 30-2 die größere zweite Dicke d2, mit d2 ≥ 2*d1, aufweisen. Im Folgenden wird die Verstärkungsstruktur 40 der Funktionsschicht 30 im Verankerungsbereich 30-2 beispielsweise auch als "Anker" bezeichnet.

Die Funktionsschicht 30 kann z.B. auch dort im Verankerungsbereich 30-2 die erste Dicke d1 aufweisen, wo die Verstärkungsstruktur 40 aufhört. Ferner kann die Verstärkungsstruktur 40 auch teilweise in den beweglichen Funktionsbereich 30-1 hineinragen. So weist die Funktionsschicht 20 ohne (vorhandene) Verstärkungsstruktur in dem beweglichen Funktionsbereich 30-1 eine erste Dicke d1 und in dem Verankerungsbereich 30-2 mit (vorhandener) Verstärkungsstruktur (als Anker) 40 eine größere zweite Dicke d2, mit d2 > d1, auf. Mit anderen Worten ausgedrückt heißt dies, dass die Funktionsschicht 20 in dem Abschnitt des beweglichen Funktionsbereichs 30-1, in dem keine Verstärkungsstruktur 40 vorhanden ist, eine erste Dicke d1 aufweist, und die Funktionsschicht 20 in dem Abschnitt des Verankerungsbereichs 30-2, in dem die Verstärkungsstruktur 40 vorhanden ist, eine größere zweite Dicke d2, mit d2 > d1, aufweist.

Gemäß einem Ausführungsbeispiel kann die erste Dicke d1 der Funktionsschicht 30 zwischen 2 und 125 µm oder zwischen 3 und 80 µm und die zweite Dicke d2 der Verstärkungsstruktur, mit d2 ≥ 2*d1, zwischen 4 und 250 µm oder zwischen 6 und 160 µm liegen.

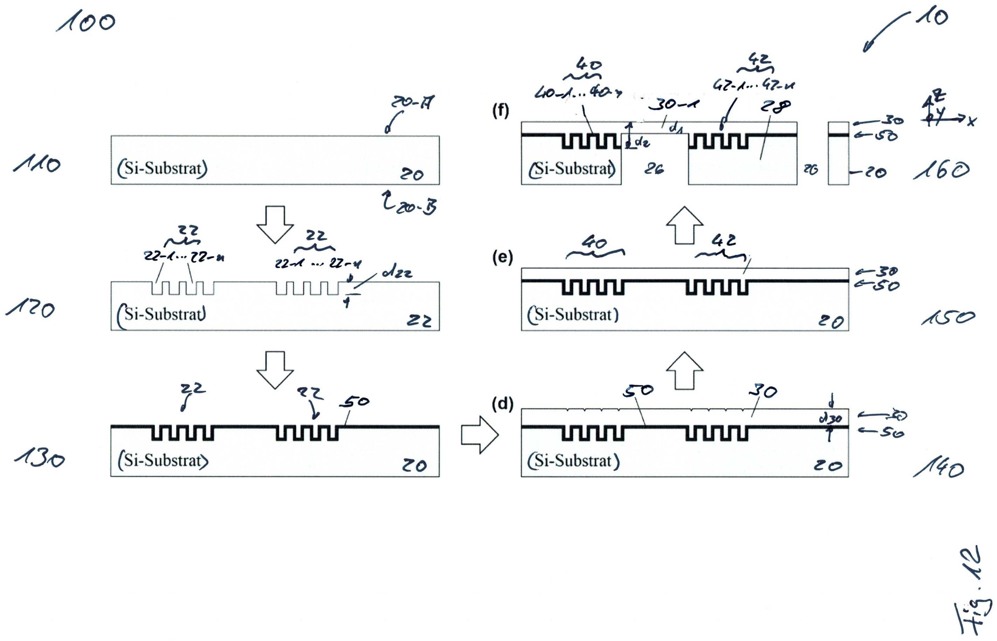

Gemäß einem Ausführungsbeispiel kann die Verstärkungsstruktur 40 als ein einteiliges (einstückiges) Verstärkungselement an dem zweiten Hauptoberflächenbereich 30-B der Funktionsschicht 30 ausgebildet sein. Gemäß einem weiteren Ausführungsbeispiel (siehe auch Fig. 12) kann die Verstärkungsstruktur 40 eine Mehrzahl von Verstärkungselementen 40-1, ..., 40-n (mit n = 2, 3, 4, ...) an dem zweiten Hauptoberflächenbereich der Funktionsschicht aufweisen.

Gemäß einem Ausführungsbeispiel ist die Verstärkungsstruktur 40 in dem Verankerungsbereich 30-2 an dem zweiten Hauptoberflächenbereich 30-B der Funktionsschicht 30 angeordnet und erstreckt sich von dem Verankerungsbereich (Einspannbereich) 30-2 der Funktionsschicht 30 in den beweglichen Funktionsbereich 30-1 der Funktionsschicht 30.

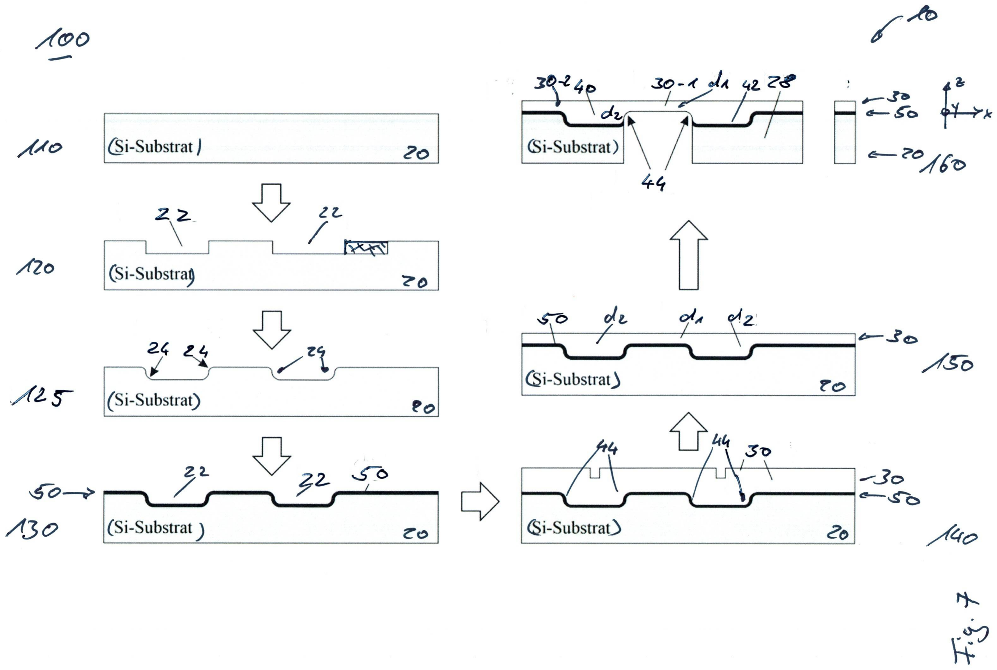

Gemäß einem Ausführungsbeispiel (siehe auch Fig. 7) sind an dem beweglichen Bereich 30-1 der Funktionsschicht 30 Kanten- und oder Eckbereiche abgerundet und weisen beispielsweise Rundungsradien zwischen 0,5 µm und 9 µm oder zwischen 1 µm und 7 µm oder zwischen 1,5 µm und 5 µm auf.

Gemäß einem weiteren Ausführungsbeispiel weist das Substrat 20 ein Siliziummaterial auf, wobei die Funktionsschicht 30 ein Poly-Si-Material und die Abdeckungsschicht 50 ein Oxidmaterial, z. B. thermisches Oxid, aufweist. Gemäß einem Ausführungsbeispiel weist die Funktionsschicht eine erste Dicke d1 von zumindest 2 µm oder zwischen 2 und 125 µm auf.

Gemäß einem weiteren Ausführungsbeispiel ist das Mikrostrukturelement 10 als ein auslenkbares Bauelement ausgebildet.

Wie in Fig. 2a bei der Ausgestaltung des beweglichen Funktionselements 30-1 als Biegebalken (oder Biegeplatte) mit einem (optionalem) Masseelement (träge Masse) 28 und in Fig. 2b bei der Ausgestaltung des beweglichen Funktionselements 30-1 als eine auslenkbare Membran, an der ein (optionale) Masseelement 28 angeordnet sein kann, dargestellt ist, kann an dem Verankerungsbereich des Masseelements 28 mit dem beweglichen Funktionselements 30-1 beispielsweise auch eine (zusätzliche) Verstärkungsstruktur 42 vorgesehen sein.

Das (optionale) Masseelement 28 kann somit an dem mit der weiteren Verstärkungsstruktur 42 versehenen, beweglichen Funktionsbereich 30-1 der Funktionsschicht 30 auslenkbar getragen werden. Die weitere Verstärkungsstruktur 42 der Funktionsschicht 30 weist beispielsweise die zweite Dicke d2, mit d2 > d1 oder d2 ≥ 2*d1, wobei die weitere Verstärkungsstruktur auch eine weitere Dicke d3, mit d3 > d1 oder d3 ≥ 2*d1 aufweisen kann, wobei d3 ≠ d2 ist. Somit können die Verstärkungsstruktur (der Anker) 40 des beweglichen Funktionsbereichs 30-1 an dem Substrat 20 und die weitere Verstärkungsstruktur (Anker) 42, z.B. an dem Masseelement 28, gleiche oder auch unterschiedliche Dicken aufweisen, aber jeweils zumindest eine Dicke > d1.

Die weitere Verstärkungsstruktur 42 kann auch ohne (das optionale) Masseelement 28, z.B. inselförmig, an dem beweglichen Funktionsbereich 30-1 des Funktionselements 30 von Fig. 2a-b angeordnet sein, um dort eine lokale Modifikation der Steifigkeit des beweglichen Funktionsbereichs 30-1 zu erhalten.

Die weitere Verstärkungsstruktur (Ankerbereich) 42 für das Masseelement ist eine optionale Ausgestaltung des beweglichen Funktionsbereichs 30-1 des Funktionselements 30 bei den im Rahmen der vorliegenden Beschreibung dargestellten Ausführungsbeispiele des erfindungsgemäßen Herstellungsverfahrens 100.

Im Folgenden werden einige wesentliche Aspekte des anhand von Fig. 1 dargestellten Herstellungsverfahrens 100 eines Mikrostrukturelements 10 sowie des anhand von Fig. 2a-b beschriebenen Mikrostrukturelements 10 nochmals zusammenfassend dargestellt.

Bei Auslenkungen des beweglichen Funktionsbereichs 30-1 der Funktionsschicht (Device Layer oder Bauelementschicht) 30 senkrecht (vertikal) zur lateralen Substratebene treten maximale mechanische Spannungen dort an einer Position des Mikrostrukturelements 10 auf, an der der bewegliche Funktionsbereich 30-1 (die bewegliche Mikrostruktur) der Funktionsschicht 30 in den starren Teil des Bauteils (des Mikrostrukturelements) 10 übergeht. Bei der erfindungsgemäßen Verankerung, wie in den Fig. 1 und 2a-b beschrieben, verbleibt der Bereich der maximalen Spannungen im Verankerungsbereich vollständig im Material der Funktionsschicht 30, d. h. im Übergangsbereich der Funktionsschicht 30 ohne Verstärkungsstruktur zu dem Funktionselement 30 mit der Verstärkungsstruktur 40. Bei ausreichend großer Dicke d2 (Ankerdicke) der Verstärkungsstruktur 40 ist das Material, z. B. das Oxidmaterial, der unter dem Verankerungsbereich 30-2 befindlichen Abdeckungsschicht 50 nur geringen mechanischen Spannungen ausgesetzt, so dass die Belastbarkeit der erfindungsgemäßen Verankerung von den mechanischen Eigenschaften des Materials, z. B. des Polysilizium-Materials, der Funktionsschicht 30 in dem Verankerungsbereich 30-2 bestimmt wird.

Die erfindungsgemäße Vorgehensweise zur Verankerung der Funktionsschicht 30, d. h. des beweglichen Funktionsbereichs 30-1 der Funktionsschicht 30, an dem Substrat 20 ermöglicht eine robuste und belastbare Ausgestaltung des Mikrostrukturelements (MEMS-Bauelements) 10. Insbesondere kann entsprechend der erfindungsgemäßen Vorgehensweise eine derartige Verteilung des mechanischen Stresses in dem Bauelement erreicht werden, dass Materialien mit geringerer mechanischer Belastbarkeit, beispielsweise die aus Siliziumoxid bestehende Abdeckschicht, nicht den maximalen mechanischen Spannungen ausgesetzt sind, die im Bereich der Verankerung auftreten können, und damit die mechanische Belastbarkeit beweglicher Mikrostrukturen, z. B. des beweglichen Funktionsbereichs 30-1 der Funktionsschicht 30 des Mikrostrukturelements 10, die beispielsweise aus einem Siliziummaterial hergestellt sind, erhöht werden. Dies wird insbesondere durch die erfindungsgemäße Verankerung der Funktionsschicht 30 mit deren beweglichen Funktionsbereich 30-1 an dem zugeordneten Substrat 20 erreicht. Die vorliegende Erfindung beschreibt ferner eine massenfertigungstaugliche Vorgehensweise, mit der eine robuste Verankerung der Funktionsschicht 30, die z. B. ein Siliziummaterial aufweist, an dem Substrat erreicht werden kann, indem die Dicke und damit die mechanische Eigenschaft der Funktionsschicht 30 am Verankerungsbereich lokal erhöht wird.

Durch die optionale Anordnung einer weiteren Verstärkungsstruktur 42 (z.B. ohne das optionale Masseelement 28) an dem freigelegten zweiten Hauptoberflächenbereich 30-B des beweglichen Funktionsbereichs 30-1 des Funktionselements 30 kann eine gezielte lokale Modifikation der Steifigkeit des beweglichen Funktionsbereichs 30-1 des Mikrostrukturelements 10, z. B. einer beweglichen Mikrostruktur für ein MEMS, erhalten werden, da die Dicke der Funktionsschicht 30 vertikal zur Substratebene bereichsweise (lokal) variiert und gezielt eingestellt werden kann. Durch die zusätzliche lokale Versteifung kann beispielsweise eine unerwünschte Deformation des beweglichen Funktionsbereichs 30-1 der Funktionsschicht 30, z. B. aufgrund von Beschleunigungskräften oder äußeren Einwirkungen im Betrieb des Mikrostrukturelements 10, verhindert oder zumindest deutlich reduziert werden.

In Fig. 2a-b sind mehrere beispielhafte Ausgestaltungen der Verstärkungsstrukturen 40, 42 an unterschiedlichen Verstärkungspositionen für die Funktionsschicht 30 dargestellt, wobei bei dem erfindungsgemäßen Herstellungsverfahren 100 an einer zu verstärkenden Position eine einzelne der Verstärkungsstrukturen 40, 42 oder an mehreren zu verstärkenden Positionen eine beliebige Kombination mehrerer Verstärkungsstrukturen 40, 42 an dem zweiten Hauptoberflächenbereich 30-B der Funktionsschicht 30 angeordnet werden kann, um die gewünschte(n) lokale(n) Versteifung(en) des beweglichen Funktionsbereichs 30-1 der Funktionsschicht 30 zu erhalten.

Bei dem erfindungsgemäßen Herstellungsverfahren 100 können beispielsweise Silizium- und/oder Polysiliziummaterialien für die Funktionsschicht 30 und die daran angeordnete Verstärkungsstruktur 40, 42 eingesetzt werden, wodurch eine hohe mechanische Belastbarkeit sowie eine gute thermische Leitfähigkeit der entsprechend ausgebildeten Funktionsschicht erhalten wird.

Das erfindungsgemäße Herstellungsverfahren 100 ermöglicht somit, dass ausgewählte Bereiche der Funktionsschicht des Mikrostrukturelements gezielt lokal versteift werden können, während andere Bereiche der Funktionsschicht flexibel und entsprechend auslenkbar bleiben. Somit kann das mit der Verstärkungsstruktur 40 versehene Mikrostrukturelement beispielsweise weiterhin als Sensor, Aktuator, Vibrations-Harvester, Inertialsensor, Lautsprecher, Mikrospiegel, Mikrofon, Drucksensor etc. aber mit erhöhter mechanischer Robustheit eingesetzt werden. Die erfindungsgemäße Vorgehensweise ist nicht nur auf die vorhergehend erwähnten Bauelemente sondern im Wesentlichen auf jegliche MEMS-Bauelemente anwendbar. Gemäß einem Ausführungsbeispiel kann das Mikrostrukturelement 10 beispielsweise auch als ein Sensorelement ausgebildet sein, um eine Auslenkung des beweglichen Funktionsbereichs 30-1 der Funktionsschicht 30 mittels einer kapazitiven, piezoelektrischen oder piezoresistiven Auslesetechnik zu erfassen.

Das erfindungsgemäße Herstellungsverfahren 100 ist ohne (wesentlich) erhöhten herstellungstechnischen Aufwand gegenüber einer herkömmlichen Vorgehensweise implementierbar und weist insbesondere eine exakte Reproduzierbarkeit der an dem beweglichen Funktionsbereich 30 angeordneten Verstärkungsstruktur(en) 40, 42 auf.

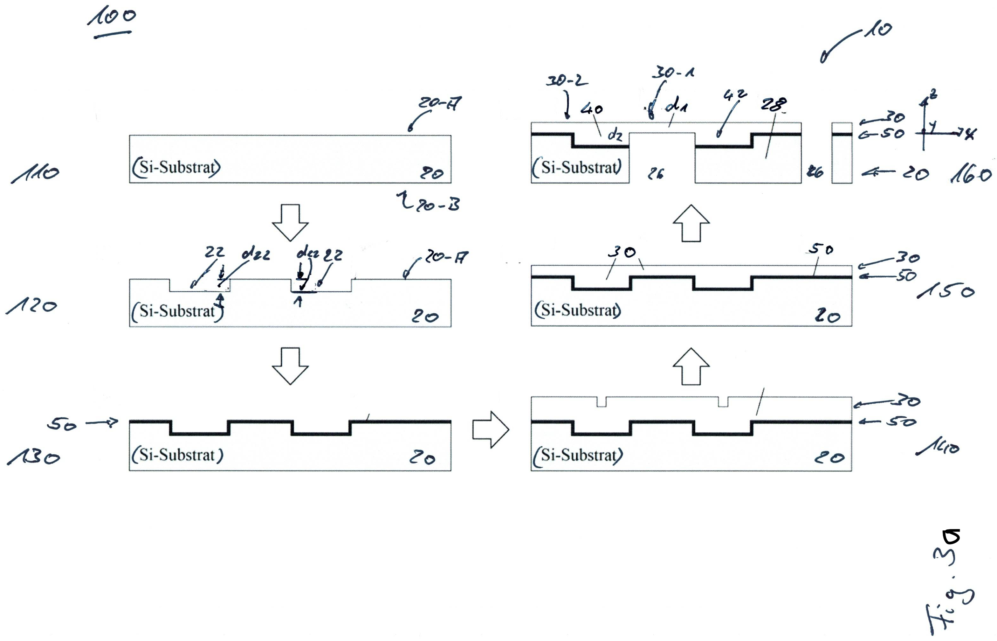

Im Folgenden wird nun anhand der Fig. 3a ein beispielhaftes, prinzipielles Ablaufdiagramm (Ablaufschema) des erfindungsgemäßen Herstellungsverfahrens 100 gemäß einem Ausführungsbeispiel dargestellt. Die Fig. 3a beschreibt nun beispielhaft eine erfindungsgemäße Vorgehensweise des Verfahrens 100 zum Herstellen eines Mikrostrukturelements 10, wobei die Funktionsschicht 30, die beispielsweise ein Halbleitermaterial wie Silizium oder Polysilizium aufweist, im Verankerungsbereich 30-2 zu dem Substrat 20 eine Verstärkungsstruktur (einen Anker) 40 mit erhöhter Dicke aufweist. Ferner kann die Dicke des beweglichen Funktionsbereichs 30-1 der Funktionsschicht 30 mittels einer weiteren Verstärkungsstruktur 42 lokal variiert werden. Das beschriebene Ausführungsbeispiel ist auf die Herstellung beliebiger MEMS-Bauelemente bzw. MEMS-Mikrostrukturen anwendbar.

Wie in Fig. 3a dargestellt ist, wird bei Schritt 110 ein Substrat 20 bereitgestellt. Das Ausgangsmaterial kann somit ein Halbleitersubstrat, wie z. B. ein Siliziumsubstrat oder ein SOI-Substrat (SOI - Silicon-On-Insulator), sein.

Bei Schritt 120 wird nun (zumindest) eine Vertiefungsstruktur 22 mit einer Tiefe d₂₂ in dem ersten Hauptoberflächenbereich 20-A des Substrats 20 angeordnet. Bei dem Schritt 120 wird die Vertiefungsstruktur 22 (mit einer oder mehreren Vertiefungen 22) beispielsweise durch Trockenätzen oder Nassätzen an den Positionen erzeugt, an denen bei den nachfolgenden Schritten dann die Verstärkungsstruktur 40, 42 (die optional auch mehrere Verstärkungselemente 40-1, ..., 40-n aufweisen kann - siehe z.B. auch Fig. 12) erzeugt werden. Bei dem Schritt 130 wird nun die Abdeckungsschicht 50 auf dem ersten Hauptoberflächenbereich 20-A und in der Vertiefungsstruktur 22 des Substrats 20 angeordnet (aufgebracht). Die Abdeckungsschicht 50 bedeckt (unabhängig von dem verwendeten Abdeckungsmaterial) nicht nur die Oberfläche 20-A des Substrats 20, sondern auch Boden und Seitenwände der Vertiefungen 22. Die Abdeckungsschicht 50 weist beispielsweise ein Isolationsmaterial, wie z. B. ein Oxidmaterial (Buried Oxide = BOX), auf. Im Fall eines Oxidmaterials kann die Oxidschicht 50 beispielsweise durch einen thermischen Oxidationsvorgang des Siliziumsubstrats z.B. als eine Siliziumoxidschicht erhalten werden.

Bei dem nachfolgenden Schritt 140 wird nun die Funktionsschicht (Device Layer) 30 auf die Abdeckungsschicht 50 auf dem ersten Hauptoberflächenbereich 20-A und in der Vertiefungsstruktur 22 des Substrats 20 aufgebracht. Die Funktionsschicht 30 kann beispielsweise als Polysilizium-Material (Poly-Si-Material) auf die Abdeckungsschicht 50 abgeschieden werden. Die Materialdicke der Funktionsschicht 30 ist dabei ausreichend groß auszubilden, um die Vertiefung(en) 22 nicht nur auszufüllen, sondern auch die Dicke der resultierenden Funktionsschicht 30 mit dem beweglichen Funktionsbereich 30-1 im Bereich der Vertiefung(en) 22 zu erhalten.

Die Funktionsschicht 30 kann beispielsweise aufgebracht werden, indem auf der Vorderseite 20-A des mit der Abdeckungsschicht 50 bedeckten Substrats 20 mittels eines CVD-Prozesses (CVD = Chemical Vapor Deposition) das Material, z. B. Polysilizium, der Funktionsschicht 30 abgeschieden wird, die dann später auch den beweglichen Funktionsbereich 30-1 der Funktionsschicht 30 bildet. Die Dicke der Funktionsschicht 30 kann beispielsweise in einem Bereich von 2 µm bis etwa 125 µm liegen.

Alternativ kann die Funktionsschicht 30 auch ein einkristallines Siliziummaterial aufweisen bzw. daraus bestehen, entsprechend einer SOI-Struktur (SOI = Silicon-On-Insulator). SOI-Substrate 20 werden beispielsweise durch Bonden und Rückdünnen von Silizium-Substraten hergestellt und sind somit auch mit dickeren Funktionsschichten 30 verfügbar.

Die Dicke der Abdeckungsschicht (Buried Oxide) 50 kann im Falle von Siliziumoxid unabhängig von der Art der Funktionsschicht 30 typischerweise in einem Bereich zwischen 0,5 µm und 2 µm liegen.

Bei dem Schritt 150 wird nun die Funktionsschicht 30 planarisiert, um den planaren (ebenen) ersten Hauptoberflächenbereich 30-A der Funktionsschicht 30 zu erhalten. Die Funktionsschicht 30 erstreckt sich an deren gegenüberliegenden, zweiten Hauptoberflächenbereich 30-B entlang des Substrats 20 und ferner in die Vertiefungsstruktur(en) 22 des Substrats 20, um in der (jeweiligen) Vertiefungsstruktur 22 die (jeweilige) Verstärkungsstruktur 40, 42 zu bilden. Bei dem Schritt 150 wird das Material der Funktionsschicht 30 planarisiert, wobei unter Umständen eine erhebliche Materialdicke (Polysiliziumdicke) abzutragen ist. Zusätzlich zu einem CMP-Vorgang (CMP = Chemical Mechanical Polishing = chemisches mechanisches Polieren) können weitere Schleif- und Polierprozesse erforderlich sein bzw. eingesetzt werden. Die resultierende Funktionsschicht 30 weist somit Bereiche mit einer geringeren ersten Dicke d1 auf, die "nahtlos" in Bereiche (Verstärkungsbereiche) 40, 42 mit einer größeren zweiten Dicke d2 oder auch dritten Dicke d3 in den Vertiefungen übergehen, d. h. die Dicke der Funktionsschicht 30 variiert lokal über der Fläche (Oberfläche) des Substrats 20.

Bei dem Schritt 160 des Freilegens des beweglichen Funktionsbereichs 30-1 der Funktionsschicht 30 wird nun das Substrat 20 (bereichsweise) unterhalb des beweglichen Funktionsbereichs 30-1 entfernt, wobei dann die Verstärkungsstruktur 40 zumindest teilweise, d.h. teilweise oder auch vollständig, in dem Verankerungsbereich 30-2 der Funktionsschicht 30 an dem Substrat 20 angeordnet ist, und wobei die Funktionsschicht 30 in dem beweglichen Funktionsbereich 30-1 ohne Verstärkungsstruktur eine erste Dicke d1 und die Funktionsschicht 30 mit der Verstärkungsstruktur 40 eine größere zweite Dicke d2, mit d2 > d1, aufweist.

Wie in Fig. 3a bei Schritt 160 beispielhaft dargestellt ist, kann das Mikrostrukturelement 10 von Fig. 2a erhalten werden, wobei der bewegliche Funktionsbereich 30-1 der Funktionsschicht 30 als ein einseitig eingespanntes Balkenelement (Cantilever, Biegebalken oder auslenkbare Platte) ausgebildet wird. Dazu wird bei dem Herstellungsschritt 160 ferner auch bereichsweise die Funktionsschicht 30 entfernt bzw. in der Ebene strukturiert, um den beweglichen Funktionsbereich 30-1 als auslenkbares Balkenelement freizulegen.

Gemäß einem weiteren Ausführungsbeispiel der vorliegenden Erfindung kann bei Schritt 160 von Fig. 3a beispielsweise auch das Mikrostrukturelement 10 von Fig. 2b erhalten werden, bei dem der bewegliche Funktionsbereich 30-1 der Funktionsschicht 30 als eine auslenkbare Membran ausgebildet sein, die entlang des Umfangs umlaufend oder abschnittsweise befestigt ist.

Bei dem Ätzprozess des Substrats (ausgehend von der Substratrückseite 20-B) von Schritt 160 kann die Abdeckungsschicht 50 beispielsweise als Ätzstoppschicht für den Ätzvorgang dienen, um die gewünschte Ausgestaltung und Topographie des zweiten Hauptoberflächenbereichs 30-B der Funktionsschicht zu erhalten. Gemäß einem Ausführungsbeispiel kann bei dem Schritt 160 ferner die Abdeckungsschicht 50 an dem beweglichen Funktionsbereich 30-1 zumindest bereichsweise, d. h. bereichsweise oder vollständig, entfernt werden. Alternativ kann die Abdeckungsschicht 50 an dem beweglichen Funktionsbereich 30-1 der Funktionsschicht 30 auch verbleiben und (falls erforderlich) beispielsweise eine Schutzfunktion für den beweglichen Funktionsbereich 30-1 z.B. gegenüber störenden Umgebungseinflüssen übernehmen.

Gemäß dem in Fig. 3a dargestellten Herstellungsverfahren 100 können in der Funktionsschicht 30 ein einzelner Bereich 40 oder auch eine Mehrzahl von Bereichen 40, 42 mit erhöhter Dicke (und damit erhöhter mechanischer Steifigkeit) erzeugt werden. Dafür wird bei dem Schritt des Anordnens 120 der Vertiefungsstruktur 22 in dem ersten Hauptoberflächenbereich des Substrats 20 eine entsprechende Anzahl von Vertiefungen 22 jeweils an einer solchen Position in dem Substrat vorgesehen, an der nachfolgend bei den weiteren Prozessschritten die Verstärkungsstruktur(en) 40, 42 an der Funktionsschicht 30 angeordnet werden soll. Die Bereiche der weiteren Vertiefungen 22 können dabei an unterschiedlichen Positionen an dem ersten Hauptoberflächenbereich 20-A des Substrats 20 oder auch innerhalb schon vorhandener Vertiefungen 22 entstehen, um beispielsweise unterschiedlich dicke Verstärkungsstrukturen 40, 42 bei den nachfolgenden Herstellungsschritten zu erhalten.

Bei dem anhand von Fig. 3a beschriebenen Herstellungsverfahren 100 zum Herstellen des Mikrostrukturelements 10, z. B. eines MEMS-Bauelements, wird mit der bereichsweise verstärkten Funktionsschicht 30 eine verstärkte Verankerung mit verbesserter mechanischer Stabilität realisiert. Das Ausgangsmaterial kann beispielsweise ein Substrat, wie z. B. ein Silizium-Substrat, sein (Schritt 110). Bei Schritt 120 (Anordnen zumindest einer Vertiefungsstruktur) werden beispielsweise durch trockenchemisches oder nasschemisches Ätzen in dem Substratmaterial die Vertiefungen 22 in den späteren Verankerungsbereichen mit der Verstärkungsstruktur 40 hergestellt. Anschließend wird bei Schritt 130 eine Abdeckungsschicht, z. B. durch thermische Oxidation eine Siliziumoxidschicht (Buried Oxide), erzeugt. Die Abdeckungsschicht 50 bedeckt dann auch den Boden und die Seitenwände der Vertiefungen 22 in dem Substrat 20. Daraufhin wird bei Schritt 140 das Material, z. B. Polysilizium, für die Funktionsschicht 30 abgeschieden. Die Materialdicke der Funktionsschicht 30 ist dabei ausreichend groß ausgelegt, um die Vertiefungen 22 nicht nur aufzufüllen, sondern auch die Dicke des beweglichen Funktionsbereichs 30-1 der Funktionsschicht 30 im Bereich der Vertiefungen 22 bereitzustellen. Anschließend wird bei Schritt 150 das Material, z. B. Polysilizium, der Funktionsschicht 30, z. B. durch Schleifen und Polieren sowie durch CMP (Chemical Mechanical Polishing = chemisch-mechanisches Polieren), planarisiert.

Bei dem Herstellungsverfahren 100 weist somit die erzeugte Funktionsschicht 30 (flexible) Bereiche mit einer ersten Dicke d1 auf, die nahtlos in Bereiche mit einer größeren zweiten Dicke d2 der in den Vertiefungen 22 ausgebildeten Verstärkungsstrukturen 40 übergehen.

Bei Schritt 160 wird das Substrat 20 bereichsweises (vertikal) unterhalb des beweglichen Funktionsbereichs 30-1 entfernt und der beweglicher Funktionsbereich 30-1 der Funktionsschicht 30 freigelegt. Gemäß dem Ausführungsbeispiel von Fig. 3a kann bei dem Herstellungsschritt 160 ferner auch bereichsweise die Funktionsschicht 30 z.B. mittels eines Vorderseitenprozesses, in der Ebene strukturiert werden, um den beweglichen Funktionsbereich 30-1 z.B. als ein auslenkbares Balkenelement zu erhalten. Die Funktionsschicht 30 kann also zum Freilegen des beweglichen Funktionsbereichs 30-1 (z.B. als auslenkbares Balkenelement) bereichsweise entfernt werden. Der Freiätzvorgang in Schritt 160 kann somit gemäß dem Ausführungsbeispiel von Fig. 3a eigentlich drei Teilprozesse aufweisen: Das (anisotrope) Ätzen des Substrats 20 von der Rückseite, das (anisotrope) Ätzen der Funktionsschicht 30 von der Vorderseite und das (isotrope oder anisotrope) Ätzen der Abdeckungsschicht 30 in den freigelegten Bereichen.

Bei Schritt 160 wird dann unter Verwendung von Halbleiterbearbeitungsprozessen der bewegliche Funktionsbereich (die bewegliche Mikrostruktur) 30-1 der Funktionsschicht 30, z. B. in Form einer flexiblen Platte des Bauelements 10, in einem Bereich der Funktionsschicht 30 mit der geringeren ersten Dicke d1 erzeugt, während die erfindungsgemäße Verankerung der Funktionsschicht 30 an dem Substrat 20 bevorzugt in Bereichen 30-2 der Funktionsschicht 30 mit der größeren Dicke d2 entsteht. Die erfindungsgemäße Verankerung wird dabei an den Positionen realisiert, an denen der bewegliche Funktionsbereich (die flexible Platte) 30-1 in starre Bereiche 30-2 des Mikrostrukturelements (MEMS-Bauelements) 10 übergeht, d. h. am Rahmen (dem Verankerungsbereich) 30-2 und bei der Darstellung in Fig. 2a-b und 3a-b auch an dem Masseelement 28.

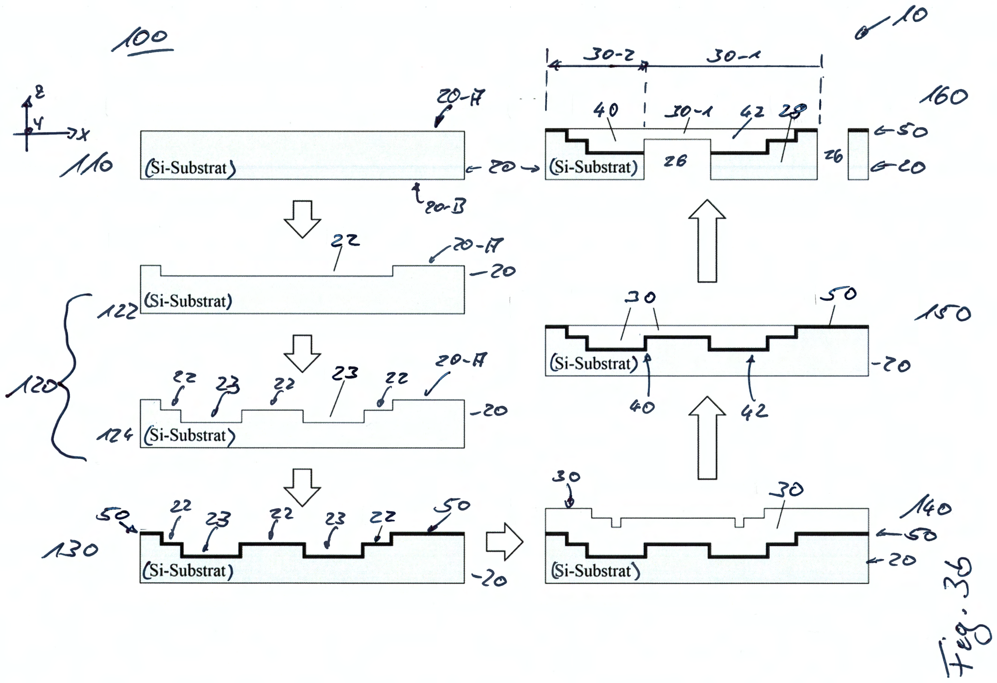

Im Folgenden wird nun anhand der Fig. 3b ein beispielhaftes, prinzipielles Ablaufdiagramm (Ablaufschema) des erfindungsgemäßen Herstellungsverfahrens 100 gemäß einem weiteren Ausführungsbeispiel dargestellt. Die Fig. 3b beschreibt nun beispielhaft eine weitere erfindungsgemäße Vorgehensweise des Verfahrens 100 zum Herstellen eines Mikrostrukturelements 10, wobei die Funktionsschicht 30, die beispielsweise ein Halbleitermaterial wie Silizium oder Polysilizium aufweist, im Verankerungsbereich 30-2 zu dem Substrat 20 eine Verstärkungsstruktur (einen Anker) 40 mit erhöhter Dicke aufweist. Ferner kann die Dicke des beweglichen Funktionsbereichs 30-1 der Funktionsschicht 30 mittels einer weiteren Verstärkungsstruktur 42 (z.B. als Anker für ein Masseelement 28) lokal variiert werden. Es wird aber darauf hingewiesen, dass das beschriebene Ausführungsbeispiel auf die Herstellung beliebiger MEMS-Bauelemente bzw. MEMS-Mikrostrukturen anwendbar ist.

Wie nun bei dem anhand von Fig. 3b dargestellten Ablaufdiagramm des erfindungsgemäßen Herstellungsverfahrens 100 beispielhaft dargestellt ist, werden wieder die Schritte 110 - 160 zum Herstellen des Mikrostrukturelements 10 durchgeführt, wobei im Unterschied zu dem anhand von Fig. 3a dargestellten Ablaufdiagramm des Herstellungsverfahrens 100 die Verstärkungsstrukturen 40, 42 mittels weiteren Vertiefungsstrukturen 23 an einer solchen Position in dem Substrat 20 angeordnet werden, dass die (dann bei Schritt 160 erhaltenen) Verstärkungsstrukturen (Verankerungen) 40, 42 vollständig an dem freigelegten zweiten Hauptoberflächenbereich 30-B des beweglichen Funktionsbereichs 30-1 des Funktionselements 30 angeordnet werden, um die erfindungsgemäße Verankerungen 40, 42 mit einer erhöhten mechanischen Stabilität dabei an den Positionen realisiert, an denen der bewegliche Funktionsbereich (die flexible Platte) 30-1 in starre Bereiche 30-2 des Mikrostrukturelements (MEMS-Bauelements) 10 übergeht, d. h. am Rahmen (dem Verankerungsbereich) 30-2 und bei der Darstellung in Fig. 2a-b und 3a-b auch an dem Masseelement 28.

In diesem Zusammenhang wird ferner darauf hingewiesen, dass die anhand des Ausführungsbeispiels von Fig. 3b dargestellte Vorgehensweise zum Erstellen der Verstärkungsstrukturen (Ankerbereiche) 40, 42 gleichermaßen auf das anhand von Fig. 12 dargestellte Ausführungsbeispiel des erfindungsgemäßen Herstellungsverfahrens 100 anwendbar ist, wobei in dem Substrat 20 die Vertiefungsstrukturen 23 mit jeweils einer Mehrzahl von Vertiefungselementen 23-1, ..., 23-n, mit n = 2, 3, 4, 5, ..., **(N** ≥ 2) an solchen Positionen vorgesehen werden, um die resultierenden Verstärkungsstrukturen (Ankerbereiche) 40, 42 mit einer Mehrzahl von Verstärkungselementen 40-1, ..., 40-n, mit n = 2, 3, 4, 5, ..., **(N** ≥ 2) und 42-1, ..., 42-n, mit n = 2, 3, 4, 5, ..., **(N** ≥ 2) zu erhalten.

Wie in Fig. 3a dargestellt ist, wird bei Schritt 110 ein Substrat 20 bereitgestellt. Das Ausgangsmaterial kann somit ein Halbleitersubstrat, wie z. B. ein Siliziumsubstrat oder ein SOI-Substrat (SOI - Silicon-On-Insulator), sein.

Bei dem Verfahren 100 wird bei Schritt 120 des Anordnens einer Vertiefungsstruktur zunächst bei einem ersten Teilschritt 122 eine erste Vertiefungsstruktur 22 mit zumindest einem ersten Vertiefungselement 22-# (mit # = 1 oder 2 oder 3 ...) in dem ersten Hauptoberflächenbereich 20-A des Substrats 20 angeordnet, und bei einem zweiten Teilschritt 124 eine zweite Vertiefungsstruktur 23 mit zumindest einem zweiten Vertiefungselement 23-# im Bereich bzw. ausgehend von (dem Bodenbereich) der ersten Vertiefungsstruktur 22 in dem Substrat 20 angeordnet bzw. in das Substrat 20 eingebracht (geätzt). Bei dem Schritt 120 wird die Vertiefungsstrukturen 22, 23 (mit einer oder mehreren Vertiefungselementen) beispielsweise durch Trockenätzen oder Nassätzen an den Positionen erzeugt, an denen bei den nachfolgenden Schritten dann die Verstärkungsstrukturen 40, 42 (die optional auch mehrere Verstärkungselemente aufweisen können - siehe z.B. auch Fig. 12) erzeugt werden.

Bei Schritt 130 wird nun die Abdeckungsschicht 50 auf dem ersten Hauptoberflächenbereich 20-A und in der Vertiefungsstrukturen 22, 23 des Substrats 20 angeordnet (aufgebracht). Die Abdeckungsschicht 50 weist beispielsweise ein Isolationsmaterial, wie z. B. ein Oxidmaterial (Buried Oxide = BOX), auf. Im Fall eines Oxidmaterials kann die Oxidschicht 50 beispielsweise durch einen thermischen Oxidationsvorgang des Siliziumsubstrats z.B. als eine Siliziumoxidschicht erhalten werden. Die Abdeckungsschicht 50 bedeckt dann nicht nur den gesamten ersten Hauptoberflächen 20-A des Substrats 20 mit dem Boden und den Seitenwänden der Vertiefungsstrukturen 22, 23.

Bei dem nachfolgenden Schritt 140 wird nun die Funktionsschicht (Device Layer) 30 auf die Abdeckungsschicht 50 auf dem ersten Hauptoberflächenbereich 20-A und in der Vertiefungsstrukturen 22, 23 des Substrats 20 aufgebracht. Die Funktionsschicht 30 kann beispielsweise als Polysilizium-Material (Poly-Si-Material) auf die Abdeckungsschicht 50 abgeschieden werden. Die Materialdicke der Funktionsschicht 30 ist dabei ausreichend groß auszubilden, um die Vertiefung(en) 22, 23 zumindest auszufüllen.

Die Funktionsschicht 30 kann beispielsweise aufgebracht werden, indem auf der Vorderseite 20-A des mit der Abdeckungsschicht 50 bedeckten Substrats 20 mittels eines CVD-Prozesses (CVD = Chemical Vapor Deposition) das Material, z. B. Polysilizium, der Funktionsschicht 30 abgeschieden wird, die dann später auch den beweglichen Funktionsbereich 30-1 der Funktionsschicht 30 bildet. Die Dicke der Funktionsschicht 30 kann beispielsweise in einem Bereich von 2 µm bis etwa 125 µm liegen.

Alternativ kann die Funktionsschicht 30 auch ein einkristallines Siliziummaterial aufweisen bzw. daraus bestehen, entsprechend einer SOI-Struktur (SOI = Silicon-On-Insulator). SOI-Substrate 20 werden beispielsweise durch Bonden und Rückdünnen von Silizium-Substraten hergestellt und sind somit auch mit dickeren Funktionsschichten 30 verfügbar.

Die Dicke der Abdeckungsschicht (Buried Oxide) 50 kann im Falle von Siliziumoxid unabhängig von der Art der Funktionsschicht 30 typischerweise in einem Bereich zwischen 0,5 µm und 2 µm liegen.

Bei Schritt 150 wird die Funktionsschicht 30 bis zu (der Ebene) der Abdeckungsschicht 50 auf dem (oberen) ersten Hauptoberflächenbereich 20-A des Substrats 20 planarisiert, um einen planaren ersten Hauptoberflächenbereich 30-A der Funktionsschicht 30 zu erhalten, wobei sich die Funktionsschicht 30 an deren gegenüberliegenden zweiten Hauptoberflächenbereich 30-B entlang des Substrats 20 und ferner in die erste und zweite Vertiefungsstruktur 22, 23 des Substrats 20 erstreckt und in der zweiten Vertiefungsstruktur 22 die Verstärkungsstrukturen (Ankerbereiche) 40, 42 bildet.

Bei Schritt 150 wird das Material der Funktionsschicht 30 planarisiert, wobei unter Umständen eine erhebliche Materialdicke (Polysiliziumdicke) abzutragen ist. Zusätzlich zu einem CMP-Vorgang (CMP = Chemical Mechanical Polishing = chemisches mechanisches Polieren) können weitere Schleif- und Polierprozesse erforderlich sein bzw. eingesetzt werden. Die resultierende Funktionsschicht 30 weist somit Bereiche mit einer geringeren ersten Dicke d1 auf, die "nahtlos" in Bereiche (Verstärkungsbereiche) 40, 42 mit einer größeren zweiten Dicke d2 (oder auch dritten Dicke d3) in den Vertiefungen 23 übergehen, d. h. die Dicke der Funktionsschicht 30 variiert lokal über der Fläche (Oberfläche) des Substrats 20.

Bei Schritt 160 kann gemäß einem Ausführungsbeispiel der bewegliche Funktionsbereich 30-1 der Funktionsschicht 30 durch bereichsweises Entfernen des Substrats 20 freigelegt werden. So kann das Substrat 20 bereichsweise, z.B. vertikal, unterhalb des beweglichen Funktionsbereichs 30-1 entfernt werden, wobei ferner bei der Rückseitenöffnung des Substrats 20 eine durchgehende Ausnehmung (Durchgangsöffnung) 26 durch das Substrat 20 gebildet wird, die sich vollständig durch das Substrat 20 und lateral um den beweglichen Funktionsbereich 30-1 der Funktionsschicht 30 erstreckt. Um den beweglichen Funktionsbereich 30-1 als auslenkbares Balkenelement zu erhalten bzw. freizulegen, ist bei dem Herstellungsschritt 160 gemäß dem Ausführungsbeispiel von Fig. 3b beispielweise kein Vorderseitenätzprozess an der Funktionsschicht 30 erforderlich.

Ferner kann bei Schritt 160 bei der Rückseitenöffnung des Substrats 20 an dem beweglichen Funktionsbereich 30-1 oder innerhalb des beweglichen Funktionsbereichs 30-1 der Funktionsschicht 30 ein starres Element 28, wie z. B. ein Masseelement (Träge-Masse-Element), gebildet werden.

Gemäß einem Ausführungsbeispiel kann der Schritt 160 des Freilegens des beweglichen Funktionsbereichs 30-1 der Funktionsschicht 30 ausgehend von dem zweiten Hauptoberflächenbereich (Rückseite) 20-B des Substrats 20 mittels eines anisotropen Ätzprozesses durchgeführt werden, um die Ausnehmung 26 bzw. die Durchgangsöffnung (Rückseitenöffnung) 26 durch das Substrat 20 zu erhalten. Ein solcher anisotroper Ätzprozess kann beispielsweise einen sogenannten Bosch-Prozess oder einen DRIE-Prozess (reaktives Ionentiefenätzen = Deep Reactive Ion Etching = DRIE) aufweisen.

Wie in Fig. 3b bei Schritt 160 beispielhaft dargestellt ist, kann das Mikrostrukturelement 10 erhalten werden, bei dem der bewegliche Funktionsbereich 30-1 der Funktionsschicht 30 als ein einseitig eingespanntes Balkenelement (Cantilever, Biegebalken oder auslenkbare Platte optional mit Masseelement in dem beweglichen Funktionsbereich 30-1 ausgebildet ist.

Fig. 4a-b zeigen nun eine Gegenüberstellung einer schematischen Teilquerschnittsansicht (a) eines Verankerungsbereichs 31-2 eines herkömmlichen MEMS-Bauelements 11 gegenüber einer schematischen Teilquerschnittsansicht (b) einer beispielhaften Ausführungsform des Verankerungsbereichs 30-2 des hergestellten Mikrostrukturelements 10 gemäß einem Ausführungsbeispiel. Die Funktionsschicht 30 und 31 kann dabei Polysilizium, die Abdeckungsschicht 50 und 51 kann Siliziumoxid (BOX = Buried Oxide) und das Substrat 20 und 21 kann einkristallines Silizium aufweisen oder jeweils daraus bestehen.

Wie in Fig. 4a beispielhaft dargestellt ist, weist ein herkömmliches MEMS-Bauelement 11 eine Funktionsschicht 31 auf, die sowohl im beweglichen Funktionsbereich 31-1 als auch im Verankerungsbereich 31-2 die gleiche Dicke d1 aufweist. Die Oxidschicht 51 ist in dem Verankerungsbereich 31-2 zwischen der Funktionsschicht 31 und dem Substrat 21 angeordnet. Aufgrund des Freiätzvorgangs des beweglichen Funktionsbereichs 31-1, wenn die Oxidschicht 51 beispielsweise durch isotropes Ätzen in einer HF-Gasphase entfernt wird, kann die Oxidschicht 51 im Bereich der Verankerung zurückgeätzt sein bzw. es entsteht eine Unterätzung (Undercut) 51-1 zwischen dem Silizium-Substrat 21 und der Funktionsschicht 31 ausgehend von der erzeugten Rückseitenöffnung 27.

Fig. 4b zeigt nun eine beispielhafte Ausführungsform des Verankerungsbereichs 30-2 des hergestellten Mikrostrukturelements 10 mit der Verstärkungsstruktur 40 gemäß einem Ausführungsbeispiel, wie dies beispielsweise anhand der Fig. 1, Fig. 2a-b und 3a beschrieben wurde.

Wie in Fig. 4b dargestellt ist, ist bei dem Mikrostrukturelement 10 die Verstärkungsstruktur 40 in dem Verankerungsbereich 30-2 der Funktionsschicht 30 an dem Substrat 20 angeordnet, wobei die Funktionsschicht in dem beweglichen Funktionsbereich ohne Verstärkungsstruktur eine erste Dicke d1 und die Funktionsschicht 30 mit der Verstärkungsstruktur 40 in dem Verankerungsbereich die größere zweite Dicke d2 aufweist. Die Abdeckungsschicht 50 (Siliziumoxid) ist zwischen der Verstärkungsstruktur 40 der Funktionsschicht 30 und dem Substrat 20 angeordnet, wobei auch hier ein Undercut (eine Unterätzung) 50-1 der Abdeckungsschicht 50 aufgrund des Freiätzvorgangs (Schritt 160) des beweglichen Funktionsbereichs 30-1 der Funktionsschicht 30 entsteht, wenn die Oxidschicht 50 beispielsweise durch isotropes Ätzen in einer HF-Gasphase entfernt wird.

Bei der erfindungsgemäßen Verankerung gemäß Fig. 4b sind der flexible Funktionsbereich (die flexible Platte) 30-1 und der Verankerungsbereich 30-2 der Funktionsschicht 30 unterschiedlich dick. Die Dicke d2 des erfindungsgemäßen Verankerungsbereichs 30-2, auch Anker 40 genannt, ergibt sich aus der Summe der Dicke d1 des beweglichen Funktionsbereichs 30-1 und der Tiefe d₂₂ der Vertiefung 22 in dem Substrat 20 (bei Schritt 120). Generell ist die Dicke d2 kleiner als die Materialdicke d₃₀ für die (bei Schritt 140) abzuscheidende Funktionsschicht 30. Im Falle von Polysilizium für die Funktionsschicht 30, das beispielsweise in Abscheidungsdicken bis zu ca. 125 µm verfügbar ist, sollte die Tiefe d22 dementsprechend einen Wert von 125 µm nicht übersteigen. Die Dicke d1 des flexiblen Funktionsbereichs 30-1 der Funktionsschicht 30 beträgt beispielsweise zumindest 2 µm.

Bei (vertikalen) Auslenkungen Δz senkrecht zur (lateralen) Substratebene entstehen maximale mechanische Spannungen S_{MAX} an Positionen, an denen die bewegliche Mikrostruktur 30-1 in den starren Teil 30-2 des Bauteils 10 übergeht. In den Fig. 4a-b sind diese Bereiche maximaler mechanischer Spannungen durch gestrichelte Kreise S_{MAX} markiert.

Bei der Verankerung gemäß dem Stand der Technik von Fig. 4a befindet sich neben dem Substratmaterial (einkristallines Silizium) 21 und dem Polysilizium der flexiblen Platte 31-1 auch das Siliziumoxid der Oxidschicht 51 im Bereich der maximalen Spannungen S_{MAX}. Die Belastbarkeit der Verankerung wird daher von den im Vergleich zu Polysilizium und einkristallinem Silizium schlechteren mechanischen Eigenschaften des Oxidmaterials (Siliziumoxid) der Oxidschicht 51 dominiert.

Dagegen verbleibt bei der erfindungsgemäßen Verankerung gemäß Fig. 4b der Bereich der maximalen Spannungen S_{MAX} vollständig in dem Material, z. B. Polysilizium, der Funktionsschicht 30 mit dem Verstärkungselement 40. Bei ausreichend großer Ankerdicke d2 ist die unter dem Anker befindliche Abdeckungsschicht (Buried Oxide) 50 nur geringen mechanischen Spannungen ausgesetzt, so dass die Belastbarkeit der erfindungsgemäßen Verankerung von den mechanischen Eigenschaften des Materials, z. B. Polysilizium, der Funktionsschicht 30 bestimmt wird.

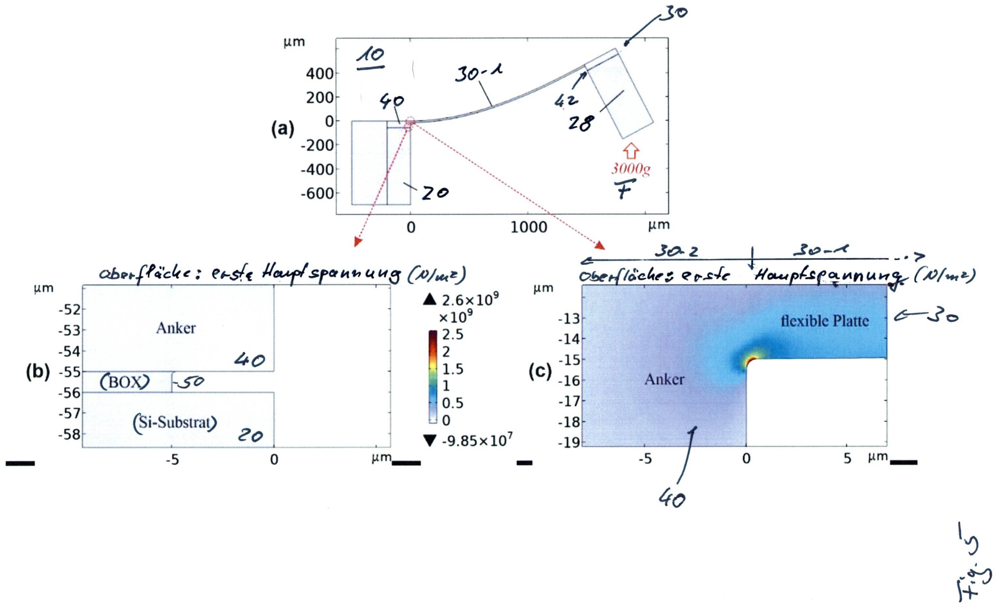

Fig. 5a-c zeigen nun beispielhaft eine 2D-FEM-Simulation (FEM = Finite-Elemente-Methode) des Mikrostrukturelements (MEMS-Bauelements) 10 gemäß Fig. 2a mit einer Verankerung gemäß Fig. 4b, auf dessen Masseelement (träge Masse) 28 eine Kraft einwirkt, die einem Schock von 3000 g entspricht. Die bewegliche Mikrostruktur 30-1 weist für die Simulation eine 1570 µm lange und 15 µm dicke flexible Platte aus Polysilizium (Funktionsschicht 30) und ein 300 µm breites Masseelement 28 auf, das das Material des Substrats 20, z. B. einkristallines Silizium, aufweist. Die Abdeckungsschicht 50 aus Siliziumoxid (BOX = Buried Oxide) ist beispielsweise 1 µm dick. Ferner wurde eine Unterätzung (Undercut) der Abdeckungsschicht 50 von 5 µm zwischen der flexiblen Platte 30-1 und dem Substrat 20 angenommen, wie sie bei dem Schritt des Freilegens 160 (Freiätzschritt) z. B. durch isotropes Ätzen der Abdeckungsschicht 50 in einer HF-Gasphase (HF = Flusssäure) entstehen kann. Das Mikrostrukturelement 10 mit der erfindungsgemäßen Verankerung weist für die Simulation eine Ankerdicke d2 von 55 µm auf, d. h. bei einer Plattendicke d1 von 15 µm wurden dafür Vertiefungen 22 in dem Substrat 20 mit einer Tiefe d22 von 40 µm vorgesehen (z.B. geätzt bei Schritt 120).

In diesem Zusammenhang wird darauf hingewiesen, dass die oben genannten Abmessungen rein beispielhaft für das 2D-FEM-Modell gewählt wurden, um die Funktionalität der erfindungsgemäßen Verankerung zu verdeutlichen. In der Praxis können aber die anhand der bisherigen Beschreibung angegebenen Bereiche für die entsprechenden Abmessungen je nach Anwendungsgebiet des MEMS-Strukturelements 10 verwendet werden.

Fig. 5a-c zeigen also (a) eine statische Simulation eines beispielhaften FEM-Modells des Mikrostrukturelements 10 mit dem erfindungsgemäßen Verankerungsbereich, eine beispielhafte Darstellung der Spannungsverteilung (first principal stress = erste Hauptspannung in N/m²) (b) unterhalb des Ankerbereichs, und (c) an der konkaven Kante im Material (z. B. Polysilizium) der Funktionsschicht 30 im erfindungsgemäßen Verankerungsbereich.

So zeigt Fig. 5a die statische Auslenkung Δz der beweglichen Mikrostruktur 30-1 unter der Einwirkung einer Kraft F, die einer Beschleunigung von 3000 g entspricht. Fig. 5b zeigt die mechanischen Spannungen im Bereich der Schicht 50 (des Buried Oxide = BOX) unterhalb des Ankers, wie dies in Fig. 5a durch den unteren gestrichelten Kreis markiert ist. Es wird eine Unterätzung der Schicht 50 von 5 µm zwischen der flexiblen Platte 30-1 und dem Substrat 20 angenommen. Eine solche Unterätzung kann durch isotropes Ätzen der Schicht 50 (Buried Oxide) in HF-Gasphase entstehen (z.B. bei Schritt 160). Die maximale Spannung in der BOX-Schicht 50 liegt beispielsweise bei ca. 0,3 GPa. Das ist unterhalb der für Siliziumoxid bekannten kritischen Werte, so dass (im vorliegenden Fall) ein Bruch am Anker nicht zu erwarten ist. Fig. 5c stellt die Verteilung der mechanischen Spannungen im Bereich der eigentlichen Verankerung dar, wie dies in Fig. 5a durch den oberen gestrichelten Kreis markiert ist. Die maximale Spannung entsteht an der konkaven Kante, an der die flexible Platte 30-1 beginnt.

Mit einem Wert von 2,6 GPa fällt die maximale Spannung aber relativ hoch aus, wobei die erfindungsgemäße Verankerung jedoch mittels einer (nachfolgend noch erläuterten) Kantenverrundung eine zusätzliche Möglichkeit bietet, hohe mechanische Spannungen, insbesondere hohe Zugspannungen, im Material, z.B. Polysilizium, der Funktionsschicht 30 zu reduzieren.

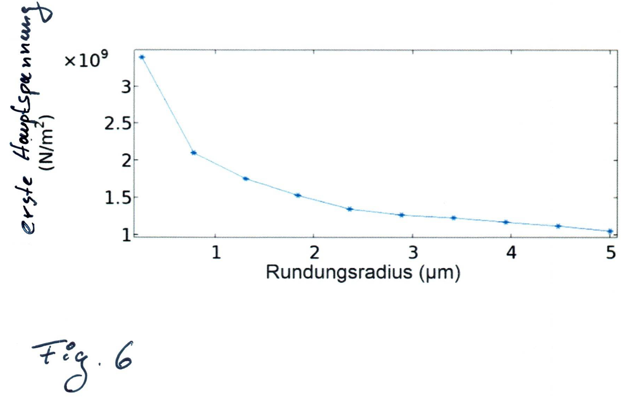

Fig. 6 zeigt nun eine grafische Darstellung des Verlaufs der maximalen mechanischen Spannung in der Verankerung des FEM-Modells in Abhängigkeit von dem Rundungsradius der konkaven Kante in dem Material (z. B. Polysilizium) der Funktionsschicht 30 in dem Verankerungsbereich 30-2. So zeigt Fig. 6 den Einfluss des Rundungsradius der konkaven Kante im Polysilizium der erfindungsgemäßen Verankerung (siehe auch Fig. 5c) auf die maximale mechanische Spannung an dieser Kante bei einer Ankerdicke d2 von 55 µm und einer Dicke d1 der flexiblen Platte von 15 µm. Die Berechnungen erfolgten für das FEM-Modell in Fig. 5a. Auf die träge Masse 28 wirkt eine Kraft, die einer Beschleunigung von 3000 g entspricht.

In Fig. 6 ist beispielhaft dargestellt, wie sich die maximale mechanische Spannung in der erfindungsgemäßen Verankerung des FEM-Modells von Fig. 5a-c mit einer Ankerdicke von 55 µm in Abhängigkeit vom Rundungsradius der konkaven Kante im Material (Polysilizium) der Funktionsschicht 30 verändert. Es wird angemerkt, dass in Fig. 5c ein Rundungsradius von 0,5 µm angenommen wird, wie er in etwa im Ergebnis der thermischen Oxidation des Substrats 20 zur Herstellung des 1 µm dicken BOX-Schicht 50 (Buried Oxide) zu erwarten ist. Schon ab einem Rundungsradius von 1 µm sinkt die maximale mechanische Spannung (in dem Übergangsbereich zwischen beweglichem Funktionsbereich 30-1 und Verstärkungsstruktur 40 im Verankerungsbereich 30-2) auf Werte unter 2 GPa ab.

Folglich ist anzunehmen, dass eine bewegliche Mikrostruktur 30-1 gemäß Fig. 5a mit einem ausreichend hohen Rundungsradius an der konkaven Kante der erfindungsgemäßen Verankerung eine Krafteinwirkung, äquivalent zu einer Beschleunigung von 3000 g, unbeschadet übersteht und somit dem Standard JESD22-B110B genügt. Fig. 6 zeigt ferner, dass mit steigendem Rundungsradius die absolute Abnahme der maximalen mechanischen Spannung zunehmend geringer wird. In diesem Zusammenhang werden Rundungsradien zwischen 0,5 µm und 9 µm oder zwischen 1 µm und 7 µm oder zwischen 1,5 µm und 5 µm als geeignet angesehen.

Rundungsradien von 1 µm und mehr lassen sich sowohl an konvexen als auch konkaven Kanten dreidimensionaler Strukturen aus einkristallinem Silizium beispielsweise durch Temperung in Wasserstoff bei Temperaturen zwischen 1000°C und 1150°C erzielen. Durch den Verrundungsprozess kommt es zudem zu einer Glättung der ersten Hauptoberfläche 20-A des Substrats 20 einschließlich der Oberflächen der zumindest einen Vertiefung. Das kann zu einer zusätzlichen Verringerung der maximalen mechanischen Spannungen an dem zweiten Hauptoberflächenbereich der Funktionsschicht 30 und somit zu einer wesentlichen Steigerung der Bruchfestigkeit des beweglichen Funktionsbereichs 30-1 führen.

Fig. 7 zeigt nun ein beispielhaftes prinzipielles Ablaufdiagramm des erfindungsgemäßen Herstellungsverfahrens gemäß einem weiteren Ausführungsbeispiel.

Wie in Fig. 7 beispielhaft dargestellt ist, kann gemäß einem weiteren Ausführungsbeispiel das Herstellungsverfahren 100 zwischen den Herstellungsschritten 120 und 130 von Fig. 3a-b einen (zusätzlichen) Schritt 125 des Durchführens eines Verrundungsprozesses von Ecken- und/oder Kantenbereichen an dem ersten Hauptoberflächenbereich 20-A des mit der Vertiefungsstruktur 22 (mit der zumindest einen Vertiefung 22) versehenen Substrats 20 aufweisen. Durch den Verrundungsprozess werden an den verrundeten (abgerundeten) konkaven und/oder konvexen Ecken- und/oder Kantenbereichen 24 an dem ersten Hauptoberflächenbereich 20-A des Substrats 20 beispielsweise Rundungsradien zwischen 0,5 µm und 9 µm, zwischen 1 und 7 µm oder zwischen 1,5 und 5 µm erhalten. Ferner kann durch den Verrundungsprozess gleichzeitig eine Glättung des ersten Hauptoberflächenbereichs des mit der Vertiefungsstruktur versehenen Substrats und insbesondere der Oberflächen der Vertiefungsstruktur mit der zumindest einen Vertiefung erreicht werden.

Für Vertiefungen, die beispielsweise mittels DRIE (bzw. Bosch-Prozess) geätzt werden, ist eine horizontale Riffelung der Seitenwände charakteristisch, auch Scalopping genannt, die durch den zyklischen Wechsel zwischen Ätzen und Passivieren entsteht. Das Scalopping ist unerwünscht, da es die mechanische Belastbarkeit freistehender MEMS-Strukturen verringert.

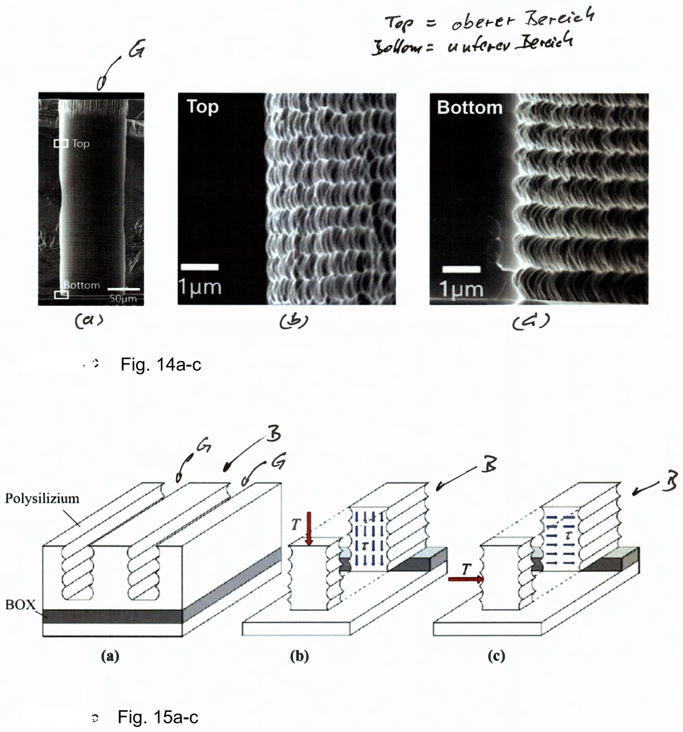

Im Folgenden wird nun beispielhaft auf die Figuren 14a-c und 15a-c Bezug genommen. Fig. Fig. 14a-c zeigen ein typisches Bespiel des Scalopping der Seitenwände einer Vertiefung mit einer Tiefe von mehreren 100 µm, erzeugt mittels DRIE (DRIE = Deep Reactive Ion Etching) in einem Si-Substrat. Oftmals sind auch noch senkrechte Riefen zu beobachten, in diesem Beispiel im oberen Bereich der Vertiefung.

Fig. 15a-c zeigen eine beispielhafte, schematische Darstellung der Strukturierung einer Poly-Silizium-Schicht mittels eines DRIE-Prozesses und der resultierenden Oberflächenbeschaffenheit der Seitenwände der erhaltenen Struktur (Cantilever). In Fig. 15a ist das Scalopping für eine oberflächen-mikromechanische Struktur aus Polysilizium schematisch dargestellt. Die Fig. 15b und 15c zeigen schematisch einen Balken "B" aus Polysilizium, freigestellt durch Ätzen des darunter befindlichen Oxids (BOX = buried oxide) und die darin erzeugten mechanischen Spannungen unter einer Belastung T, die von oben bzw. von der Seite auf die freistehende Struktur einwirkt. Numerische Simulationen ergaben, dass die Bruchfestigkeit einer derartigen, Scalopping aufweisenden Struktur um bis zu 50% geringer sein kann im Vergleich zu einer identischen Struktur ohne Scalopping.

Es können beispielsweise unterschiedliche Vorgehensweisen eingesetzt werden, um das Scalopping zu reduzieren. So kann ein Trockenätzen (RIE) in SF6-Plasma verwendet werden, um das Scalopping von Vertiefungen in einkristallinem Silizium zu verringern. Ferner kann das Glätten der Seitenwände von in einkristallinem Silizium erzeugten Vertiefungen mittels Oxidation und anschließendes Entfernen der Oxidschicht durchgeführt werden.

Gemäß einem Ausführungsbeispiel kann der Verrundungsprozess bei Schritt 125 an dem ersten Hauptoberflächenbereich 20-A des Substrats 20 ebenfalls mit einem Trockenätzprozess, einem Oxidationsprozess oder einem Temperungsprozess in Wasserstoff, z.B. bei Temperaturen zwischen 1000°C und 1150°C, durchgeführt werden.

Der Verrundungsprozess zur Erzeugung von Rundungsradien von 0,5 - 9 µm, oder 1 - 7 µm oder 1,5 - 5 µm, angewandt auf Vertiefungen im einkristallinen Si-Substrat, kann demnach auch das Scalopping substantiell reduzieren bzw. die Seitenwände der Vertiefungen substantiell glätten. Durch die Verrundung von Kanten und Ecken an dem sowie die Glättung des ersten Hauptoberflächenbereichs des mit der zumindest einen Vertiefung versehenen Substrats können dann entsprechend verrundete (abgerundete) Ecken und Kanten und glatte Oberflächen an dem zweiten Hauptoberflächenbereich der Funktionsschicht und damit an der (dann erhaltenen) Verstärkungsstruktur erhalten werden. Aufbauend darauf kann eine bewegliche Mikrostruktur (z.B. ein Spiegel, ein Cantilever oder auch eine Membran) erzeugt werden, die allseitig von geglätteten Oberflächen ohne Scalopping begrenzt ist und fast nur verrundete konvexe und konkave Ecken und Kanten aufweist. Dadurch können maximale mechanische Spannungen in der Funktionsschicht deutlich (gegenüber einem nicht-verrundeten und ungeglätteten Zustand) reduziert und die Bruchfestigkeit eines MEMS-Bauelements noch zusätzlich über das bisher betrachtete Maß hinaus erhöht werden.

In der Praxis können Mikrostrukturelemente 10, wie z.B. MEMS-Bauelemente, sehr hohen mechanischen Belastungen ausgesetzt sein, die aber trotz einer hohen mechanischen Beanspruchung nicht zum Ausfall des beweglichen Mikrostrukturelements 10 führen sollten. Vibrations-Harvester, Inertialsensoren oder Mikrospiegel können z. B. sehr hohe Beschleunigungen durch Vibrationen, Stöße oder Fallereignisse erfahren. Fluide können Druckstöße auf die beweglichen Strukturen (den beweglichen Funktionsbereich 30-1) von Mikrofonen oder Drucksensoren ausüben. Auch andere Kräfte, die auf Teile des Bauelements 10 einwirken, können kritische mechanische Spannungen in der beweglichen Mikrostruktur, d. h. dem beweglichen Funktionsbereich 30-1 der Funktionsschicht 30, verursachen. Da sehr hohe mechanische Spannungswerte häufig an scharfen Kanten und Ecken eines Mikrostrukturelements (MEMS-Bauelements) auftreten, wird durch den in Schritt 125 des Herstellungsverfahrens 100 dargestellten Verrundungsprozess mit der Verrundung (Abrundung) von Kanten und Ecken 44 der Funktionsschicht 30 und einer Glättung der Oberflächen eine deutliche Reduzierung der maximal auftretenden, mechanischen Spannungen (Belastungen) an dem Mikrostrukturelement 10 erhalten. Durch die Verrundung der konkaven bzw. konvexen Kanten 44 an der Funktionsschicht 30, insbesondere in dem beweglichen Funktionsbereich 30-1, und der Glättung der Oberflächen kann somit die Belastbarkeit des Mikrostrukturelements 10 deutlich erhöht und beispielsweise mehr als verdoppelt werden.

Wie aus Fig. 7 ferner ersichtlich ist, werden bis auf den Verrundungsprozess 125 ansonsten bei dem dort dargestellten Herstellungsverfahren 100 die gleichen Prozessschritte 110 - 160 wie in dem anhand von Fig. 1 und Fig. 3a-b dargestellten Herstellungsverfahren 100 durchgeführt, so dass die dortige Beschreibung des Prozessablaufs hier gleichermaßen anwendbar ist.

Das Verfahren 100 gemäß Fig. 7 stellt somit dar, wie die Erzeugung verrundeter Kanten in die Fertigung der erfindungsgemäßen Verankerung gemäß Fig. 3a-b integriert werden kann. Das Ausgangsmaterial ist z.B. ein herkömmliches Si-Substrat (siehe Schritt 110). In Analogie zu Fig. 3a-b werden zuerst Vertiefungen 22 erzeugt (siehe Schritt 120). Anschließend erfolgt das Verrunden der konvexen und konkaven Kanten der geätzten Strukturen, z.B. durch H2-Annealing des Si-Substrats 20 (siehe Schritt 125). Die weitere Vorgehensweise stimmt wieder mit Fig. 3a-b überein. Nach Erzeugung der Abdeckungsschicht 50 BOX (siehe Schritt 130), wird das Material der Funktionsschicht 30, z.B. Polysilizium, abgeschieden (siehe Schritt 140). Anschließend wird das Material der Funktionsschicht 30 planarisiert, z.B. durch Schleifen und Polieren, bis die vorgesehene Dicke der Funktionsschicht 30 erreicht ist () siehe Schritt 150). Abschließend wird die bewegliche Mikrostruktur 30-1 erzeugt (siehe Schritt 160). Dafür wird die Funktionsschicht strukturiert, das Substratmaterial von der Rückseite des Substrats mit Ätzstopp auf der Abdeckungsschicht 50 weggeätzt und anschließend (optional) die Abdeckungsschicht 50 in den geätzten Bereichen entfernt.

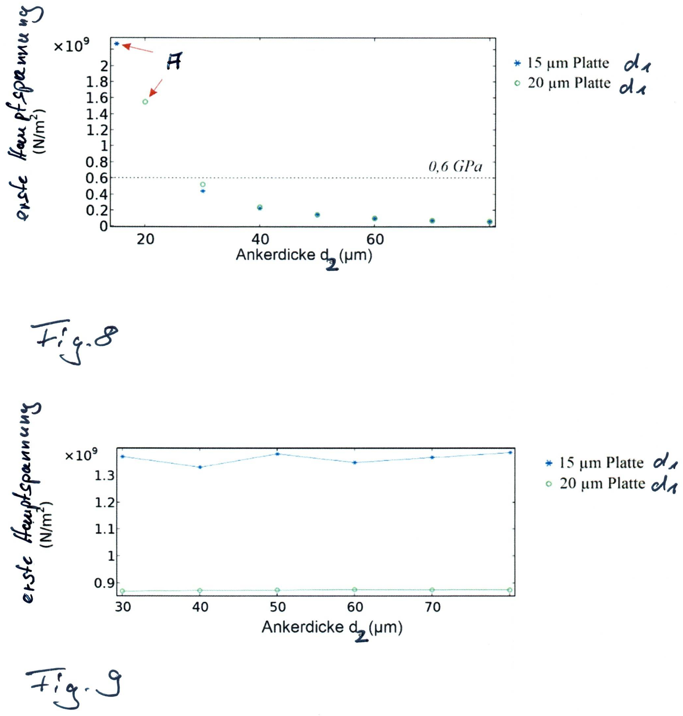

Fig. 8 zeigt nun eine grafische Darstellung der maximalen mechanischen Spannung in der Abdeckungsschicht (vergrabenes Oxid = BOX) 50 unterhalb des Ankerbereichs 30-2 für zwei unterschiedliche Dicken (Plattendicken) d1 des beweglichen Funktionsbereichs 30-1 in Abhängigkeit von der Dicke d2 des Ankerbereichs (z.B. für das FEM-Modell von Fig. 5a-c). Auf die träge Masse wirkt beispielsweise eine Kraft, die einer Beschleunigung von 3000 g entspricht. Für die konkave Kante im Material (z.B. Polysilizium) der Funktionsschicht 30, der eigentlichen Verankerung (siehe Fig. 5c) wurde ein Rundungsradius von 2,5 µm angesetzt.

Fig. 8 illustriert beispielhaft den Einfluss der (zweiten) Dicke d2 des Ankers und der (ersten) Dicke d1 der flexiblen Platte 30-1 auf die maximale mechanische Spannung in der Abdeckungsschicht (BOX) 50 unterhalb des Ankers (siehe auch Fig. 5b). Für Fig. 8 wird das FEM-Model gemäß Fig. 5a verwendet. Auf die träge Masse wirkt eine Kraft, die einer Beschleunigung von 3000 g entspricht. Die ersten beiden Punkte "A" für jede Plattendicke d1 mit Ankerdicken d2 von 15 µm bzw. 20 µm zeigen noch sehr hohe Spannungswerte, d.h. weit oberhalb eines Werts von 0,6 GPa, der z.B. als Grenzwert (Untergrenze) für die mechanische Spannung von Siliziumoxid der Oxid-Schicht 50 zur Vermeidung eines Materialbruchs angenommen werden kann. Der Darstellung von Fig. 8 ist somit zu entnehmen, die Dicke d2 des Ankers die Dicke d1 der flexiblen Platte für d1 zwischen 15 µm und 20 µm möglichst um einen Faktor von mindestens 2 übersteigen sollte, damit die mechanische Spannung im BOX 50 kleiner 0,6 GPa bleibt. Höhere Faktoren sind von Vorteil. Die absolute Abnahme der maximalen mechanischen Spannung wird mit steigendem Verhältnis jedoch zunehmend geringer.

Fig. 9 zeigt nun eine grafische Darstellung der maximalen mechanischen Spannung an der konkaven Kante in dem Material (z. B. Polysiliziummaterial) des erfindungsgemäßen Verankerungsbereichs 30-2 für zwei Plattendicken d1 des beweglichen Funktionsbereichs 30-1 in Abhängigkeit von der Dicke d2 des Ankerbereichs 30-2. Die Berechnungen basieren wieder auf dem FEM-Modell in Abb. 5a. Auf die träge Masse 28 wirkt eine Kraft, die einer Beschleunigung von 3000 g entspricht. Für die konkave Kante im Material (Polysilizium) der Funktionsschicht 30 wird ein Rundungsradius von 2,5 µm angenommen.

Wie aus Fig. 9 ersichtlich ist, hat die (zweite) Dicke d2 des Ankers nahezu keinen Einfluss auf die maximale mechanische Spannung an der konkaven Kante im Material (Polysilizium) der Funktionsschicht 30 der erfindungsgemäßen Verankerung, wenn die Kante verrundet ist (siehe auch Fig. 5c). Dies ist in Fig. 9 für Plattendicken d1 von 15 µm und 20 µm für diejenigen Ankerdicken d2, für die gemäß Fig.8 die mechanische Spannung im BOX 50 unterhalb der Grenze von 0,6 GPa verbleibt. Bei den Berechnungen wird wieder das FEM-Model von Fig. 5a verwendet. Auf die träge Masse 28 wirkt eine Kraft, die einer Beschleunigung von 3000 g entspricht. Aus Fig. 9 ist somit ersichtlich, dass für Plattendicken d1 zwischen 15 µm und 20 µm bereits eine Ankerdicke d2 von 30 µm ausreichend ist, um Schocks von 3000 g zu überstehen.

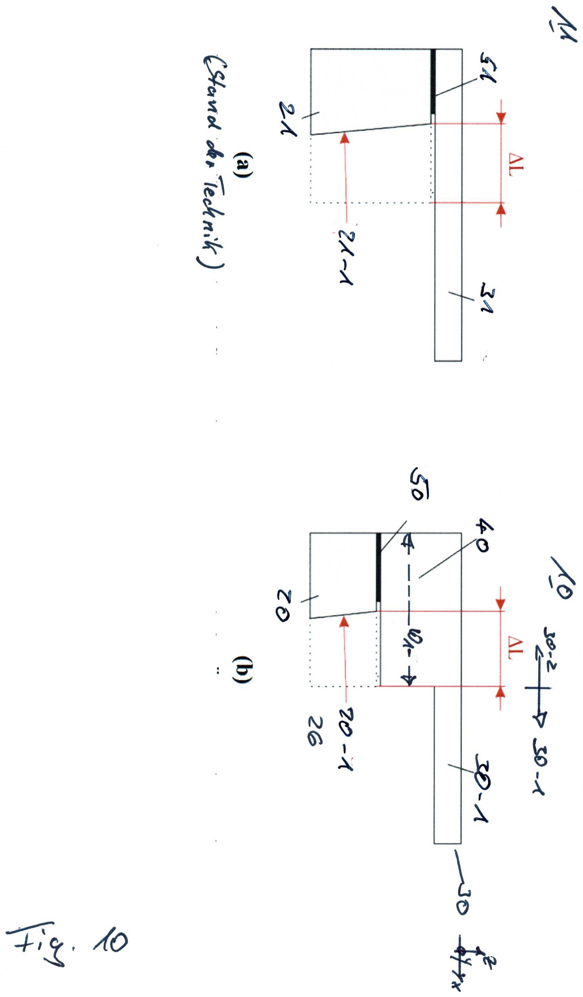

Fig. 10a-b zeigen nun eine Gegenüberstellung einer schematischen Teilquerschnittsansicht (a) eines Verankerungsbereichs 31-2 eines herkömmlichen MEMS-Bauelements 11 gegenüber einer schematischen Teilquerschnittsansicht (b) einer beispielhaften Ausführungsform des "hergestellten" Mikrostrukturelements 10 mit dem erfindungsgemäßen Verankerungsbereich 30-2 gemäß einem weiteren Ausführungsbeispiel.

Wie im Vorhergehenden anhand des Herstellungsverfahrens 100 beschrieben wurde, kann gemäß einem Ausführungsbeispiel der Schritt 160 des Freilegens des beweglichen Funktionsbereichs 30-1 der Funktionsschicht 30 ausgehend von dem zweiten Hauptoberflächenbereich 20-B des Substrats 20 z.B. mittels eines anisotropen Ätzprozesses durchgeführt werden, um die Rückseitenöffnung 26 durch das Substrat 20 zu erhalten. Ein solcher anisotroper Ätzprozess kann beispielsweise ein sogenannter Bosch-Prozess oder ein DRIE-Prozess sein.

Bei einem solchen Ätzvorgang können die Seitenwände 20-1 der DRIE-geätzten Durchgangsöffnung 26 typischerweise nicht senkrecht ausgebildet werden, so dass es zu einer Aufweitung der Rückseitenöffnung (Ausnehmung) 26 in dem Substrat 20 mit zunehmender Ätztiefe, d.h. mit zunehmendem Abstand von dem zweiten Hauptoberflächenbereich 20-B des Substrats 20, kommt. Diese Aufweitung wird auch als Unterätzen oder Undercut bezeichnet, wobei diese Aufweitung der Rückseitenöffnung 26 in Fig. 10a-b mit dem Abstand ΔL beispielhaft angegeben ist. Da sowohl der Neigungswinkel der Seitenwände als auch der Undercut der Ätzmaskierung über das Substrat variieren können, bleibt auch ΔL nicht konstant. In Abhängigkeit vom DRIE-Prozess und der Ätztiefe kann ΔL durchaus 100 µm betragen und gleichzeitig um mehrere 10 µm über das Substrat (Wafer) variieren.

Eine entsprechende Ausgestaltung der Verstärkungsstruktur 40 im Verankerungsbereich 30-2 der Funktionsschicht 30 an dem Substrat 20 kann auch dann eine mechanisch sichere Verankerung des beweglichen Funktionsbereichs 30-1 der Funktionsschicht an dem Substrat 20 sicherstellen, wenn der Ätzvorgang zum Erzeugen der Rückseitenöffnung 26 durch das Substrat 20 die (häufig unvermeidbare) prozesstechnische Abweichungen ΔL aufweist.

Im Falle einer Verankerung gemäß dem Stand der Technik (siehe Fig. 10a) geht ΔL direkt in die lateralen Abmessungen der flexiblen Platte 31 ein. Bei der erfindungsgemäßen Verankerung (siehe Fig. 10b) entsteht ΔL hingegen unterhalb des Ankers 40, so dass die lateralen Abmessungen der flexiblen Platte 30-1 (mit der Dicke d1) unverändert bleiben. Dementsprechend wird die laterale Breite w1 der Anker (Verstärkungsstruktur) 40 der erfindungsgemäßen Verankerung zumindest größer gewählt, als das für den konkreten Herstellungsprozess maximal mögliche Wert ΔL. Der Wert ΔL kann hier der Länge des freistehenden Teils des Ankers entsprechen, da die Kante des Ankers mit der Kante der Rückseitenöffnung zusammenfällt, wie in Fig. 4b oder Fig. 5c dargestellt. Eine Obergrenze für die Breite der Verstärkungsstruktur 40 besteht nicht bzw. wird durch das Design des Bauelements 10 vorgegeben.

Durch die erfindungsgemäßen Verankerung der Funktionsschicht 30 kann im Vergleich zu einer herkömmlichen Anordnung der Einfluss von Prozess-Variationen auf die Abmessungen der beweglichen Mikrostruktur 30-1 verringert werden.

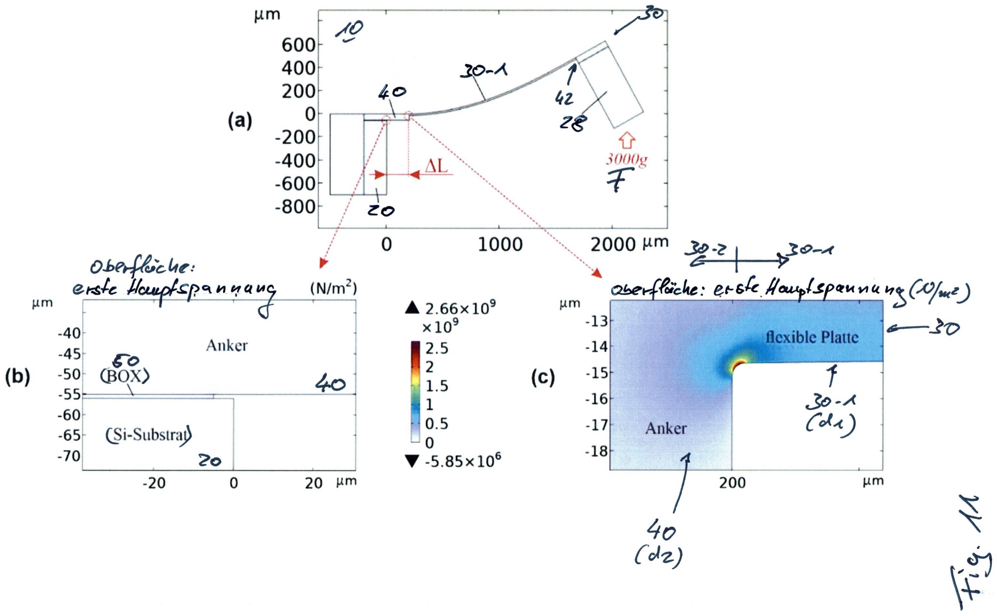

Fig. 11a-c zeigen nun (a) eine statische Simulation eines beispielhaften FEM-Modells des Mikrostrukturelements mit dem erfindungsgemäßen Verankerungsbereich, (b) eine beispielhafte Darstellung der Spannungsverteilung (erste Hauptspannung in N/m² unterhalb des Ankerbereichs, und (c) an der konkaven Kante im Material (z. B. Polysilizium) der Funktionsschicht im erfindungsgemäßen Verankerungsbereich (aber im Unterschied zu Fig. 5a-c mit einem "Undercut" ΔL unterhalb des erfindungsgemäßen Verankerungsbereichs und einem Verrundungsradius (von 0,5 µm) der konkaven Kante im Übergang zwischen dem beweglichen Funktionselement 30-1 und der Verstärkungsstruktur 40.

Fig. 11a-c zeigt den Einfluss einer freistehenden Ankerlänge bzw. eines Undercut ΔL von 200 µm auf die Spannungsverteilung im der Oxide-Schicht 50 (Buried Oxide) unterhalb des Ankers 40 sowie an der konkaven Kante im Material (Polysilizium) der Funktionsschicht 30 für ein zu Fig. 5a-c äquivalentes 2D-FEM-Modell mit einer Ankerdicke d2 von 55 µm und einer Plattendicke d1 von 15 µm. Es wurde hier z.B. angenommen, dass die Kante des Ankers mit der Kante der Rückseitenöffnung zusammenfällt, so wie in Fig. 4b und Fig. 5c dargestellt.

Fig. 11a zeigt die Verformung der flexiblen Platte unter einer statischen Kraft, die einer Beschleunigung von 3000 g entspricht und auf die träge Masse 28 wirkt. Fig. 11b illustriert die resultierende Spannungsverteilung unterhalb des Ankers 40. Es wird eine Unterätzung von 5 µm zwischen der flexiblen Platte 30-1 und dem Substrat 20 angenommen, wie sie beispielsweise durch isotropes Ätzen des 1 µm dicken BOX 50 (Buried Oxide) in einer HF-Gasphase entstehen kann. Fig. 11c zeigt die Spannungsverteilung an der konkaven Kante 44 im Material (Polysilizium) der Funktionsschicht 30. Die maximale Spannung im Material (Polysilizium) der Funktionsschicht 30 mit 2,66 GPa nur um ca. 2% höher als bei dem Bauelement 10 ohne Undercut, siehe Fig. 5c. Somit kann angenommen werden, dass bei einer Ankerdicke d2 von 55 µm eine Unterätzung ΔL bis zu 100 µm sowie eine Variation der Unterätzung ΔL von mehreren 10 µm über den Wafer 20 nahezu keinen Einfluss auf die Spannungsverteilung in der erfindungsgemäßen Verankerung haben.

Fig. 12 zeigt nun ein beispielhaftes prinzipielles Ablaufdiagramm des erfindungsgemäßen Herstellungsverfahrens 100 gemäß einem weiteren Ausführungsbeispiel.

Wie nun bei dem anhand von Fig. 12 dargestellten Ablaufdiagramm des erfindungsgemäßen Herstellungsverfahrens 100 beispielhaft dargestellt ist, werden wieder die Schritte 110 - 160 zum Herstellen des Mikrostrukturelements 10 durchgeführt, wobei im Unterschied zu dem anhand von Fig. 3a-b dargestellten Ablaufdiagramm des Herstellungsverfahrens 100 die Verstärkungsstruktur 40 mit einer Mehrzahl von Verstärkungselementen 40-1, ..., 40-n, mit n = 2, 3, 4, 5, ..., (N ≥ 2) ausgebildet wird.

Gemäß dem Ausführungsbeispiel des Herstellungsverfahrens 100 von Fig. 12 kann die Verstärkungsstruktur 40 mit einer Mehrzahl von Verstärkungselementen 40-1, ..., 40-n an dem zweiten Hauptoberflächenbereich 30-B der Funktionsschicht 30 angeordnet werden. So können beispielsweise die Verstärkungselemente 40-1, ..., 40-n benachbart angeordnet und/oder miteinander, z. B. gitterförmig, verbunden sein, wobei die Verstärkungselemente z. B. länglich, lamellenförmig, rippenförmig, wabenförmig, gitterförmig, elliptisch, kreisförmig, wellen- oder bogenförmig etc. an dem zweiten Hauptoberflächenbereich 30-B der Funktionsschicht 30 angeordnet sein können. Die Ausgestaltung der Verstärkungselemente 40-1, ..., 40-n der Verstärkungsstruktur 40 kann beispielsweise von der Form des beweglichen Funktionsbereichs 30-1, von der Verankerung des beweglichen Funktionsbereichs 30-1 an dem Substrat 20 und/oder der gewünschten lokalen Steifigkeit der Funktionsschicht 30 bzw. des beweglichen Funktionsbereichs 30-1 der Funktionsschicht 30 abhängen.

Gemäß dem Ausführungsbeispiel des Herstellungsverfahrens 100 von Fig. 12 können die Vertiefungselemente 22-1, ..., 22-n der Vertiefungsstruktur 22 mit einer maximalen Breite w₂ in dem ersten Hauptoberflächenbereich 20-A des Substrats 20 angeordnet werden, wobei die Funktionsschicht 30 mit einer Schichtdicke aufgebracht wird, die zumindest der halben maximalen Breite der Vertiefungselemente 22-1, ..., 22-n entspricht. Somit kann die maximale Breite der einzelnen Vertiefungselemente 22-1, ..., 22-n weniger als die halbe Dicke der Funktionsschicht 30 betragen, wobei die Vertiefungselemente 22-1, ..., 22-n aber unter Berücksichtigung dieser Randbedingung auch unterschiedliche Breiten zueinander aufweisen können.

Gemäß dem Ausführungsbeispiel des Herstellungsverfahrens 100 von Fig. 12 kann bei Schritt 120 die Vertiefungsstruktur 22 mit den Vertiefungselementen 22-1, ..., 22-n an einer solchen Position in dem Substrat 20 angeordnet werden, dass die (dann bei Schritt 140, 150 erhaltene) Verstärkungsstruktur 40 mit den Verstärkungselementen 40-1, ..., 40-n an dem zweiten Hauptoberflächenbereich 30-B der Funktionsschicht 30 zumindest teilweise in einem Verankerungsbereich der Funktionsschicht an dem Substrat angeordnet ist, um z.B. eine lokale Modifikation der Steifigkeit des beweglichen Funktionsbereichs 30-1 im Verankerungsbereich zu erhalten. Die Funktionsschicht 30 in dem beweglichen Funktionsbereich 30-1 ohne Verstärkungsstruktur weist eine erste Dicke d1 und die Funktionsschicht 30 mit der Verstärkungsstruktur 40 in dem Verankerungsbereich 30-2 eine größere zweite Dicke d2, mit d2 > d1, auf.

Gemäß einem weiteren Ausführungsbeispiel des Herstellungsverfahrens 100 von Fig. 12 kann die Vertiefungsstruktur 22 mit den Vertiefungselementen 22-1, ..., 22-n (bei Schritt 120) auch zusätzlich an einer solchen Position in dem Substrat 20 angeordnet werden, dass die (dann bei Schritt 140, 150 erhaltene) weitere Verstärkungsstruktur 42 mit den Verstärkungselementen 42-1, ..., 42-n vollständig an dem freigelegten zweiten Hauptoberflächenbereich 30-B des beweglichen Funktionsbereichs 30-1 des Funktionselements 30 angeordnet wird, um eine lokale Modifikation der Steifigkeit des beweglichen Funktionsbereichs 30-1 zu erhalten.

Die Anzahl und Anordnung der Vertiefungselemente 22-1, ..., 22-n in dem ersten Hauptoberflächenbereich 20-A des Substrats 20 und die daraus resultierende Anzahl und Anordnung der Verstärkungselemente 40-1, ..., 40-n der Verstärkungsstruktur 40 an dem zweiten Hauptoberflächenbereich 30-B der Funktionsschicht 30 können im Wesentlichen frei gestaltet werden. Die Vertiefungen 22 bzw. die Verstärkungselemente 42 können einen i. W. beliebigen Verlauf aufweisen und z. B. elliptisch oder kreisförmig, oder wellen- oder bogenförmig gestaltet sein, solange die gewünschte lokale Versteifung der Funktionsschicht 30 erhalten wird. Die Vertiefungen 22-1, ..., 22-n bzw. Verstärkungselemente 40-1, ..., 40- können sich auch überschneiden, um z. B. ein Gitter zu bilden. Der Wiederholabstand der Vertiefungen 22 bzw. Verstärkungselemente 42 kann i. W. beliebig sein und ist nicht auf einen konstanten Wert beschränkt, solange die gewünschte lokale Versteifung der Funktionsschicht 30 erhalten wird.

Bei dem in Fig. 12 dargestellten weiteren Ausführungsbeispiel des erfindungsgemäßen Herstellungsverfahrens 100 können beispielsweise eine oder mehrere, weitere Versteifungsstrukturen 42 (vollständig) in dem beweglichen Funktionsbereich 30-1 der Funktionsschicht 30 angeordnet werden. Gleichermaßen können die Verstärkungselemente 40-1, ..., 40-n der Verstärkungsstruktur 40 auch an einem Verankerungsbereich 30-2 der Funktionsschicht 30 an dem Substrat 20 vorgesehen werden und sich (von dort) teilweise in den beweglichen Funktionsbereich 30-1 der Funktionsschicht 30 erstrecken.

Ferner ist der im Vorhergehenden beschriebene Schritt 125 des Durchführens eines Verrundungsprozesses von Ecken- und/oder Kantenbereichen 24 an dem ersten Hauptoberflächenbereich 20-A des mit der zumindest einen Vertiefung 22 versehenen Substrats 20 des Herstellungsverfahrens 100 auch hier gleichermaßen anwendbar, um eine Verrundung konvexer und/oder konkaver Kanten und Ecken 44 (vor allem in dem beweglichen Funktionsbereich 30-1) der Funktionsschicht 30 zu erhalten und besonders glatte Oberflächen im zweiten Hauptoberflächenbereich der Funktionsschicht zu erhalten.

Fig. 12 zeigt also eine weitere Vorgehensweise des Herstellungsverfahrens 100, um die erfindungsgemäße Verankerung gemäß einem weiteren Ausführungsbeispiel zu realisieren. Im Vergleich zur Vorgehensweise gemäß dem Herstellungsverfahren 100 von Fig. 3a-b und 7 können mit dem Herstellungsverfahren 100 von Fig. 12 die Kosten der Herstellung einer erfindungsgemäßen Verankerung verringert werden.

Im Folgenden wird der Verfahrensablauf von Fig. 12 nochmals beispielhaft für Siliziumprozessschritte dargestellt und zusammengefasst, wobei das Verfahren 100 auch auf andere Materialien, wie Metalle, Halbleitermaterialien und Isolationsmaterialien anwendbar ist. Das Ausgangsmaterial ist z.B. wieder ein Si-Substrat 20 (siehe Schritt 110 von Fig. 12). Im Unterschied zur Vorgehensweise von Fig. 3a-b wird für jeden Anker 40 anstatt einer einzelnen Vertiefung 22 eine Anzahl schmaler Vertiefungen 22-1, .., 22-n in das Si-Substrat 20 geätzt (siehe Schritt 120 von Fig. 12). Im Gegensatz zur ersten Variante der erfindungsgemäßen Verankerung gemäß Fig. 3a-b sollte die Breite w2 der Vertiefungen 22-1, .., 22-n zumindest geringer sein als die doppelte Dicke d30 der abzuscheidenden Polysiliziumschicht (Funktionsschicht) 30. Anschließend wird das Buried Oxide 50 erzeugt (siehe Schritt 130 von Fig. 12), und das Polysilizium für den Device Layer (Funktionsschicht) 30 abgeschieden (siehe Schritt 140 von Fig. 12). Die Vertiefungen 22-1, ..., 22-n werden dabei durch das Polysilizium 30 aufgefüllt und überdeckt. Die Dicke d30 der Polysiliziumschicht 30 kann in etwa bzw. zumindest der Dicke d1 Device Layer 30 entsprechen. Anschließend wird das Polysilizium 30 planarisiert, z. B. mittels CMP (siehe Schritt 150 von Fig. 12). Schritt 160 von Fig. 12 illustriert die anschließende Erzeugung der beweglichen Mikrostruktur 30-1 unter Verwendung von Halbleiterprozesstechniken in Analogie zu den Vorgehensweisen gemäß den Fig. 3a-bund 7.

Gemäß dem Ausführungsbeispiel des erfindungsgemäßen Herstellungsverfahrens 100 von Fig. 12 können vergleichsweise geringe Herstellungskosten realisiert werden, da die Materialdicke des bei Schritt 140 abzuscheidenden Materials (Polysiliziums) der Funktionsschicht 30 nur geringfügig dicker als die angestrebte Dicke d1 für das bewegliche Funktionsbereichs 30-1 der Funktionsschicht 30 ist. Folglich ist auch die Planarisierung des Materials (Polysiliziums) der Funktionsschicht 30 wesentlich weniger aufwendig.

Die erfindungsgemäße Verankerung gemäß dem in Fig. 12 beschriebenen Ausführungsbeispiel des Herstellungsverfahrens 100 kann auch mit einer Verrundung konvexer und konkaver Kanten im Materials (Polysilizium) der Funktionsschicht 30 realisiert werden, wie dies anhand von Fig. 7 beschrieben ist.

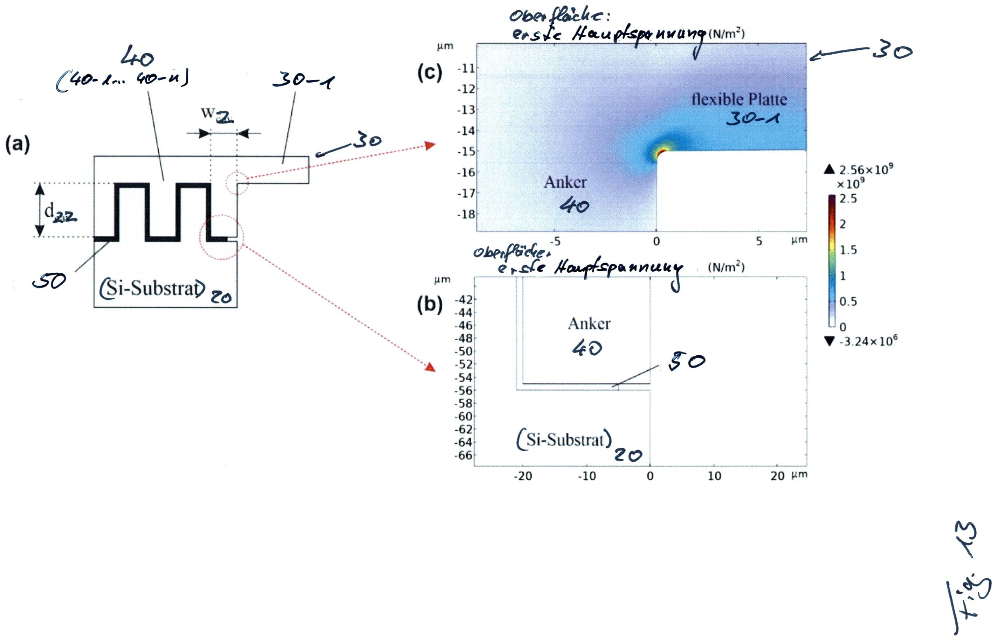

Fig. 13a-c zeigen eine (a) schematische und (b) vergrößerte Darstellung der erfindungsgemäßen Verankerung mit einem beispielsweise gitterförmigen Ankerbereich 40 sowie (c) der resultierenden Spannungsverteilung unterhalb des Ankerbereichs 40 und der Spannungsverteilung an einer konkaven Kante im Material (z. B. Polysilizium) der Funktionsschicht 30. Der Rundungsradius dieser Kante beträgt 0,5 µm.

Fig. 13a-c zeigen die Verteilung der mechanischen Spannung in einer Verankerung, die gemäß dem in Fig. 12 beschriebenen Ausführungsbeispiel des Herstellungsverfahrens 100 hergestellt wurde, unter Einwirkung einer statischen Kraft auf die träge Masse 28, die einer Beschleunigung von 3000 g entspricht. Bis auf die Ausgestaltung des Verankerungsbereichs mit dem gitterförmigen Ankerbereich 40 entspricht das hier verwendete 2D-FEM-Modell den 2D-FEM-Modellen, die anhand der Fig. 5a-c und Fig. 11a-c genutzt wurden.

Wie aus der schematischen 2D-Darstellung von Fig. 13a hervorgeht, wird der Anker 40 durch eine Anzahl von Verstärkungselementen 40-1, ..., 40-n in den Vertiefungen 22-1, .., 22-n mit einer Tiefe d22 von 40 µm und einer Breite w2 von 20 µm bei einem Wiederholabstand von 20 µm gebildet. Fig. 13b zeigt die Spannungsverteilung unterhalb des Ankers 40. Es wurde eine Unterätzung von 5 µm zwischen der flexiblen Platte 30-1 und dem Substrat 20 angenommen, wie sie beispielsweise durch isotropes Ätzen des 1 µm dicken Buried Oxide 50 in HF-Gasphase entstehen kann. Fig. 13c zeigt die Spannungsverteilung an der konkaven Kante im Material (Polysilizium) im Übergang zwischen dem beweglichen Funktionselement 30-1 und der Verstärkungsstruktur 40. Die maximalen Spannungswerte im Buried Oxide 50 und im Polysilizium 30-1, 40 sind noch etwas geringer als im Falle der erfindungsgemäßen Verankerung entsprechend der in Fig. 5a-c dargestellten, erfindungsgemäßen Vorgehensweise.

Die Anzahl und Anordnung der Vertiefungselemente 22-1, ..., 22-n in dem ersten Hauptoberflächenbereich 20-A des Substrats 20 und die daraus resultierende Anzahl und Anordnung der Verstärkungselemente 40-1, ..., 40-n der Verstärkungsstruktur 40 an dem zweiten Hauptoberflächenbereich 30-B der Funktionsschicht 30 können im Wesentlichen frei gestaltet werden, um eine optimale Verteilung der mechanischen Spannung in der erfindungsgemäßen Verankerung zu erreichen.

Die Vertiefungen 22 bzw. die Verstärkungselemente 42 können einen i. W. beliebigen Verlauf aufweisen und z. B. elliptisch oder kreisförmig, oder wellen- oder bogenförmig gestaltet sein, solange die gewünschte lokale Versteifung der Funktionsschicht 30 erhalten wird. Die Vertiefungen 22-1, ..., 22-n bzw. Verstärkungselemente 40-1, ..., 40- können sich auch überschneiden, um z. B. ein Gitter zu bilden. Der Wiederholabstand der Vertiefungen 22 bzw. Verstärkungselemente 42 kann i. W. beliebig sein und ist nicht auf einen konstanten Wert beschränkt, solange die gewünschte lokale Versteifung der Funktionsschicht 30 erhalten wird. In diesem Fall würde eine Aufweitung (Unterätzung) der zu ätzenden Strukturen um einen Wert ΔL, wie in Fig. 11a-c beispielhaft dargestellt, keinen Einfluss auf die Stabilität der erfindungsgemäßen Verankerung haben.

Die Breite w2 der Vertiefungen 22-1, .., 22-n sollte zumindest geringer sein als die doppelte Materialdicke d30 der abzuscheidenden Polysiliziumschicht (Funktionsschicht) 30. Die Tiefe d22 der Vertiefungen 22 kann hingegen auch größer sein als 100 µm bzw. kann (theoretisch) beliebige Werte annehmen. Die Grenze hängt vom Material des Device Layers 30 bzw. des zur Verfügung stehenden Prozesses zur Abscheidung dieses Materials ab.

Die im vorhergehenden anhand des Herstellungsverfahrens 100 und des Mikrostrukturelements 10 beschriebenen erfindungsgemäßen Verankerungen, auch in Kombination mit einer Verrundung konkaver und konvexer Kanten und einer Glättung der Oberflächen des zweiten Hauptoberflächenbereichs der Funktionsschicht, sind prinzipiell für alle MEMS-Bauelemente geeignet, die eine bewegliche Mikrostruktur basierend auf einem Device Layer 30 enthalten und eine möglichst hohe Belastbarkeit der beweglichen Mikrostruktur 30-1 erfordern. Die erfindungsgemäßen Verankerungen können überall an solchen Positionen eines MEMS-Bauelements realisiert werden, an denen flexible Bereiche 30-1 der beweglichen Mikrostruktur in starre Bereiche 30-2 der Funktionsschicht 30 übergehen oder an denen flexible Bereiche 30-1 der beweglichen Mikrostruktur an einem starren Rahmen 20 des Bauelements 10 fixiert sind.

Entsprechende volumen-mikromechanisch hergestellte Bauelemente wären z. B. Vibrations-Harvester, Inertialsensoren, Lautsprecher, Mikrospiegel, Mikrofone oder Drucksensoren. Kritische mechanischen Spannungen entstehen dabei vor allem bei übermäßiger Belastung der beweglichen Mikrostruktur 30-1, im Falle von Vibrations-Harvestern, Inertialsensoren und Mikrospiegeln z.B. durch Schocks oder im Falle von Drucksensoren und Lautsprechern z.B. durch Überdruck bzw. Druckstöße. Auch andere Kräfte, die auf Teile des Bauteils einwirken, können kritische mechanische Spannungen in der beweglichen Mikrostruktur verursachen.

Die im vorhergehenden anhand des Herstellungsverfahrens 100 und des Mikrostrukturelements 10 beschriebenen, erfindungsgemäßen Verankerungen sind auch in oberflächenmikromechanischen Bauelementen anwendbar sowie in Bauelementen, bei deren Herstellung oberflächen- und volumen-mikromechanische Techniken kombiniert werden. Generell ist die Anwendung einer erfindungsgemäßen Verankerung nicht auf die beschriebenen Beispiele und erwähnten MEMS-Bauelemente beschränkt.

Im folgenden werden Abmessungen und Materialien des erfindungsgemäßen Herstellungsverfahrens 100 und des Mikrostrukturelements 10 nochmals beispielhaft für Siliziumherstellungsprozesse zusammengefasst.

In den beschriebenen Ausführungsbeispielen kann der Device Layer 30 Polysilizium aufweisen oder daraus bestehen. Die Dicke d30 der für den Device Layer 30 abgeschiedenen Polysiliziumschicht sollte z.B. mehr als 2 µm, (bevorzugt) mehr als 3 µm oder (besonders bevorzugt) mehr als 5 µm betragen. Als (technische) Obergrenze kann im Falle von Polysilizium ein Wert für d30 von 125 µm angenommen werden. Insbesondere sind Schichtdicken zwischen 3 µm und 80 µm (besonders) geeignet. Der Device Layer 30 kann auch einkristallines Silizium oder anderen Materialien, wie z.B. Metalle oder Dielektrika, aufweisen oder daraus bestehen. Die Dicke des Materials wird durch die Möglichkeiten der verfügbaren Abscheideprozesse vorgegeben.

Die Funktionsschicht 30 kann beispielweise auch zumindest teilweise (oder vollständig) als ein Stapel aus zwei oder mehr Schichten desselben Materials oder aus unterschiedlichen Materialien aufgebracht werden. Dabei kann eine zusätzliche Schicht für die (resultierende) Funktionsschicht bzw. den Funktionsschichtstapel z. B. nach dem Planarisieren (Schritt 150 des Herstellungsverfahrens 100) aufgebracht werden. Ferner können einzelne oder alle Schichten der Funktionsschicht planarisiert werden oder der Funktionsschichtstapel abschließend bei Schritt 150 planarisiert werden. Durch die Ausgestaltung der Funktionsschicht als Schichtstapel lassen sich deren mechanische Eigenschaften einstellen bzw. erhöhen.

Anstelle von Siliziumoxid, d.h. des Buried Oxide, für die Abdeckungsschicht 50 können ebenfalls alternative Materialien verwendet werden, insofern sie kompatibel sind zur Abscheidung des Device Layers 30 bzw. zum Herstellungsprozess des MEMS-Bauelements 10 und sich selektiv entfernen lassen, ohne dass die bewegliche Mikrostruktur 30-1 oder andere essenzielle Komponenten des MEMS-Bauelements 10 beschädigt werden.

Ein Device Layer 30 aus Metall oder einem dielektrischen Material kann z.B. mit einer Polysilizium-Schicht anstelle des Buried Oxide für die Abdeckungsschicht 50 kombiniert werden. Polysilizium kann in XeF2-Gasphase isotrop geätzt werden mit hoher Selektivität zu vielen anderen Materialien.

Die im vorhergehenden anhand des Herstellungsverfahrens 100 und des Mikrostrukturelements 10 beschriebenen erfindungsgemäßen Verankerungen, auch in Kombination mit einer Verrundung konkaver und/oder konvexer Kanten und einer Glättung der Oberflächen der Funktionsschicht 30 können eine Verbesserung der mechanischen Belastbarkeit einer beweglichen, freistehenden Mikrostruktur 30-1 des Mikrostrukturelements (MEMS-Bauelements) 10, die z.B. unter Verwendung eines Si-Substrats 20 mit einem Device-Layer 30 aus Polysilizium oder einkristallinem Silizium und einem Buried Oxide 50 hergestellt wurde, bereitstellen. Ferner können beispielsweise herstellungsbedingte Schwankungen der mechanischen Eigenschaften der beweglichen Mikrostruktur 30-1 des MEMS-Bauelements 10 reduziert werden.

Die beschriebenen Ausführungsbeispiele des erfindungsgemäßen Herstellungsverfahrens 100 und des erfindungsgemäßen Mikrostrukturelements 10 sind anwendbar auf alle MEMS-Bauelemente mit beweglichen Mikrostrukturen, die beim Transport, im Betrieb oder in Extremsituationen mechanische Belastungen erfahren können, die in der Verankerung der beweglichen Mikrostruktur 30-1 hohe mechanische Spannungen erzeugen. Beispiele für entsprechende Bauteile sind Vibrations-Harvester, Mikrospiegel, Lautsprecher, Mikrofone, Drucksensoren, Inertialsensoren, Resonatoren, etc.

Im Folgenden werden zusätzliche Ausführungsbeispiele und Aspekte der Erfindung beschrieben, die einzeln oder in Kombination mit beliebigen der hierin beschriebenen Merkmale, Funktionalitäten und Einzelheiten verwendet werden können.

Gemäß einem ersten Aspekt kann ein Verfahren 100 zum Herstellen eines Mikrostrukturelements folgende Schritte aufweisen: Bereitstellen 110 eines Substrats, Anordnen 120 einer Vertiefungsstruktur in einem ersten Hauptoberflächenbereich des Substrats, Anordnen 130 einer Abdeckungsschicht auf dem ersten Hauptoberflächenbereich und in der Vertiefungsstruktur des Substrats, Aufbringen 140 einer Funktionsschicht auf der Abdeckungsschicht auf dem ersten Hauptoberflächenbereich und in der Vertiefungsstruktur des Substrats, Planarisieren 150 der Funktionsschicht, um einen planaren ersten Hauptoberflächenbereich der Funktionsschicht zu erhalten, wobei sich die Funktionsschicht an deren gegenüberliegenden zweiten Hauptoberflächenbereich entlang des Substrats und ferner in die Vertiefungsstruktur des Substrats erstreckt und in der Vertiefungsstruktur eine Verstärkungsstruktur bildet; und Freilegen 160 eines beweglichen Funktionsbereichs der Funktionsschicht zumindest durch bereichsweises Entfernen des Substrats unterhalb des beweglichen Funktionsbereichs, wobei die Verstärkungsstruktur zumindest teilweise in einem Verankerungsbereich der Funktionsschicht an dem Substrat angeordnet ist, und wobei die Funktionsschicht ohne Verstärkungsstruktur eine erste Dicke d1 und die Funktionsschicht mit der Verstärkungsstruktur eine größere zweite Dicke d2, mit d2 > d1, aufweist.

Gemäß einem zweiten Aspekt unter Bezugnahme auf den ersten Aspekt kann die Vertiefungsstruktur mit einer solchen Tiefe in dem Substrat angeordnet und die Funktionsschicht mit einer solchen Dicke auf das Substrat aufgebracht werden, dass nach dem Planarisieren die Verstärkungsstruktur der Funktionsschicht in dem Verankerungsbereich eine größere zweite Dicke d2, mit d2 ≥ 2*d1, aufweist.

Gemäß einem dritten Aspekt unter Bezugnahme auf den ersten oder zweiten Aspekt kann die Vertiefungsstruktur mit einer solchen Tiefe in dem Substrat angeordnet und die Funktionsschicht mit einer solchen Dicke auf das Substrat aufgebracht werden, dass nach dem Planarisieren die erste Dicke d1 der Funktionsschicht zwischen 2 und 125 µm oder zwischen 3 und 80 µm und die zweite Dicke d2 der Verstärkungsstruktur, mit d2 ≥ 2*d1, zwischen 4 und 250 µm oder zwischen 6 und 160 µm liegt.

Gemäß einem vierten Aspekt unter Bezugnahme auf zumindest einen des ersten bis dritten Aspekts kann bei dem Schritt des Freilegens eines beweglichen Funktionsbereichs der Funktionsschicht ferner die Abdeckungsschicht (vertikal) unterhalb des beweglichen Funktionsbereichs zumindest bereichsweise entfernt werden.

Gemäß einem fünften Aspekt unter Bezugnahme auf zumindest einen des ersten bis vierten Aspekts kann die Verstärkungsstruktur als ein einteiliges Verstärkungselement an dem zweiten Hauptoberflächenbereich der Funktionsschicht angeordnet werden.

Gemäß einem sechsten Aspekt unter Bezugnahme auf zumindest einen des ersten bis vierten Aspekts kann die Verstärkungsstruktur mit einer Mehrzahl von Verstärkungselementen an dem zweiten Hauptoberflächenbereich der Funktionsschicht angeordnet werden.

Gemäß einem siebten Aspekt unter Bezugnahme auf den sechsten Aspekt kann die Vertiefungselemente der Vertiefungsstruktur mit einer Mehrzahl von Vertiefungselementen mit einer maximalen Vertiefungsbreite in dem ersten Hauptoberflächenbereich des Substrats angeordnet werden, und wobei die Funktionsschicht mit einer Schichtdicke aufgebracht werden kann, die zumindest der halben maximalen Vertiefungsbreite der Vertiefungselemente entspricht.

Gemäß einem achten Aspekt unter Bezugnahme auf zumindest einen des ersten bis siebten Aspekts kann das Verfahren ferner folgenden Schritt aufweisen: Durchführen 125 eines Verrundungsprozesses von Kantenbereichen an dem ersten Hauptoberflächenbereich des mit der zumindest einen Vertiefung versehenen Substrats, um an den Kantenbereichen Rundungsradien zwischen 0,5 µm und 9 µm, zwischen 1 und 7 µm oder zwischen 1,5 µm und 5 µm vorzusehen.

Gemäß einem neunten Aspekt unter Bezugnahme auf den achten Aspekt kann der Verrundungsprozess mit einem Trockenätzprozess, Naßätzprozess, Oxidationsprozess oder Temperungsprozess in Wasserstoff durchgeführt werden.

Gemäß einem zehnten Aspekt unter Bezugnahme auf zumindest einen des ersten bis neunten Aspekts kann der Schritt des Freilegens des beweglichen Funktionsbereichs der Funktionsschicht ausgehend von dem zweiten Hauptoberflächenbereich mittels eines anisotropen Ätzprozesses durchgeführt werden.

Gemäß einem elften Aspekt unter Bezugnahme auf zumindest einen des ersten bis zehnten Aspekts kann das Substrat ein Siliziummaterial, die Funktionsschicht ein Poly-Si-Material und die Abdeckungsschicht ein Oxidmaterial aufweisen.

Gemäß einem zwölften Aspekt unter Bezugnahme auf zumindest einen des ersten bis elften Aspekts kann das Mikrostrukturelement als ein auslenkbares Bauelement ausgebildet werden.

Gemäß einem dreizehnten Aspekt unter Bezugnahme auf zumindest einen des ersten bis zwölften Aspekts kann bei dem Schritt 120 des Anordnens einer Vertiefungsstruktur 22; 22, 23 eine erste Vertiefungsstruktur 22 mit zumindest einer ersten Vertiefung 22-# in dem ersten Hauptoberflächenbereich 20-A des Substrats 20 angeordnet werden 122, und eine zweite Vertiefungsstruktur 23 mit zumindest einer zweiten Vertiefung 23-# im Bereich bzw. ausgehend von der ersten Vertiefungsstruktur 22 in dem Substrat 20 angeordnet werden 124, wobei bei dem Schritt 130 die Abdeckungsschicht 50 auf dem ersten Hauptoberflächenbereich 20-A und in der ersten und zweiten Vertiefungsstruktur 22, 23 des Substrats 20 angeordnet werden kann, wobei bei dem Schritt 140 die Funktionsschicht 30 auf der Abdeckungsschicht 50 auf dem ersten Hauptoberflächenbereich 20-A und in der ersten und zweiten Vertiefungsstruktur 22, 23 des Substrats 20 aufgebracht werden kann; und wobei bei dem Schritt 150 die Funktionsschicht 30 bis zu (der Ebene) der Abdeckungsschicht 50 auf dem ersten Hauptoberflächenbereich 20-A des Substrats 20 planarisiert werden kann, um einen planaren ersten Hauptoberflächenbereich 30-A der Funktionsschicht 30 zu erhalten, wobei sich die Funktionsschicht 30 an deren gegenüberliegenden zweiten Hauptoberflächenbereich 30-B entlang des Substrats 20 und ferner in die erste und zweite Vertiefungsstruktur 22, 23 des Substrats 20 erstrecken und in der zweiten Vertiefungsstruktur 23 die Verstärkungsstruktur 40, 42 bilden kann.

Gemäß einem vierzehnten Aspekt kann ein Mikrostrukturelement 10 folgende Merkmale aufweisen: ein mit einer Ausnehmung 26 versehenes Substrat 20, und einer Funktionsschicht 30, die mit einem beweglichen Funktionsbereich 30-1 die Ausnehmung 26 in dem Substrat 20 überspannt und einen planaren ersten Hauptoberflächenbereich 30-A aufweist, wobei ein zweiter gegenüberliegender Hauptoberflächenbereich 30-B der Funktionsschicht 30 an einem Randbereich 30-2 mit dem Substrat 20 gekoppelt ist, und wobei die Funktionsschicht 30 an deren zweiten Hauptoberflächenbereich 30-B mindestens eine mit der Funktionsschicht direkt verbundene oder einstückig ausgebildete Verstärkungsstruktur 40 aufweist, wobei die mindestens eine Verstärkungsstruktur 40, 42 zumindest teilweise in einem Verankerungsbereich 30-2 der Funktionsschicht 30 an dem Substrat 20 angeordnet ist, und wobei die Funktionsschicht 30 in dem beweglichen Funktionsbereich 30-1 ohne Verstärkungsstruktur eine erste Dicke d1 und die Funktionsschicht 30 mit der Verstärkungsstruktur in dem Verankerungsbereich eine größere zweite Dicke d2, mit d2 > d1, aufweist.

Gemäß einem fünfzehnten Aspekt unter Bezugnahme auf den vierzehnten Aspekt kann die Verstärkungsstruktur 40 der Funktionsschicht 30 in dem Verankerungsbereich die größere zweite Dicke d2, mit d2 ≥ 2*d1, aufweisen.

Gemäß einem sechzehnten Aspekt unter Bezugnahme auf den vierzehnten oder fünfzehnten Aspekt kann die Verstärkungsstruktur 40 als ein einteiliges Verstärkungselement angeordnet sein.

Gemäß einem siebzehnten Aspekt unter Bezugnahme auf den vierzehnten oder fünfzehnten Aspekt kann die Verstärkungsstruktur 40 eine Mehrzahl von Verstärkungselementen 40-1, ..., 40-n aufweisen, die an dem zweiten Hauptoberflächenbereich 30-B der Funktionsschicht 30 angeordnet sind.

Gemäß einem achtzehnten Aspekt unter Bezugnahme auf zumindest einen des vierzehnten bis siebzehnten Aspekts kann die erste Dicke d1 der Funktionsschicht 30 zwischen 2 und 125 µm oder zwischen 3 und 80 µm und die zweite Dicke d2 der Funktionsschicht 30 mit der Verstärkungsstruktur 40, mit d2 ≥ 2*d1, zwischen 4 und 250 µm oder zwischen 6 und 160 µm liegen.

Gemäß einem neunzehnten Aspekt unter Bezugnahme auf zumindest einen des vierzehnten bis achtzehnten Aspekts können Kantenbereiche 44 an dem beweglichen Bereich 30-1 der Funktionsschicht 30 abgerundet sein und Rundungsradien zwischen 0,5 µm und 9 µm, zwischen 1 und 7 µm oder zwischen 1,5 und 5 µm aufweisen.

Gemäß einem zwanzigsten Aspekt unter Bezugnahme auf zumindest einen des vierzehnten bis neunzehnten Aspekts kann das Substrat 20 ein Siliziummaterial, die Funktionsschicht ein Poly-Si-Material und die Abdeckungsschicht ein Oxidmaterial aufweisen.

Gemäß einem einundzwanzigsten Aspekt unter Bezugnahme auf zumindest einen des vierzehnten bis zwanzigsten Aspekts kann das Mikrostrukturelement 10 als ein auslenkbares Bauelement ausgebildet sein.

Obwohl einige Aspekte der vorliegenden Offenbarung als Merkmale im Zusammenhang einer Vorrichtung beschrieben wurden, ist es klar, dass eine solche Beschreibung ebenfalls als eine Beschreibung entsprechender Verfahrensmerkmale betrachtet werden kann. Obwohl einige Aspekte als Merkmale im Zusammenhang mit einem Verfahren beschrieben wurden, ist klar, dass eine solche Beschreibung auch als eine Beschreibung entsprechender Merkmale einer Vorrichtung bzw. der Funktionalität einer Vorrichtung betrachtet werden können.

In der vorhergehenden detaillierten Beschreibung wurden teilweise verschiedene Merkmale in Beispielen zusammen gruppiert, um die Offenbarung zu rationalisieren. Diese Art der Offenbarung soll nicht als die Absicht interpretiert werden, dass die beanspruchten Beispiele mehr Merkmale aufweisen als ausdrücklich in jedem Anspruch angegeben sind. Vielmehr kann, wie die folgenden Ansprüche wiedergeben, der Gegenstand in weniger als allen Merkmalen eines einzelnen offenbarten Beispiels liegen. Folglich werden die folgenden Ansprüche hiermit in die detaillierte Beschreibung aufgenommen, wobei jeder Anspruch als ein eigenes separates Beispiel stehen kann. Während jeder Anspruch als ein eigenes separates Beispiel stehen kann, sei angemerkt, dass, obwohl sich abhängige Ansprüche in den Ansprüchen auf eine spezifische Kombination mit einem oder mehreren anderen Ansprüchen zurückbeziehen, andere Beispiele auch eine Kombination von abhängigen Ansprüchen mit dem Gegenstand jedes anderen abhängigen Anspruchs oder einer Kombination jedes Merkmals mit anderen abhängigen oder unabhängigen Ansprüchen umfassen. Solche Kombinationen seien umfasst, es sei denn es ist ausgeführt, dass eine spezifische Kombination nicht beabsichtigt ist. Ferner ist beabsichtigt, dass auch eine Kombination von Merkmalen eines Anspruchs mit jedem anderen unabhängigen Anspruch umfasst ist, selbst wenn dieser Anspruch nicht direkt abhängig von dem unabhängigen Anspruch ist.

### Literaturliste:

[1] Merz et al., "PSM-X2 - Polysilicon surface micromachining process platform for vacuum-packaged sensors", Proc. MST-Kongress, Freiburg, Germany, 1.012 Oct. 2005
[2] Marenco et al., "Investigation of key technologies for system-in-package integration of inertial MEMS", Proc DTIP, Rome, Italy, 1-3 April 2009
[3] Vercesi et al., "Thelma-double - A new technology platform for manufacturing of high-performance MEMS inertial sensors", Proc. MEMS, Tokyo, Japan, 9-13 Jan. 2022
[4] Hong et al., "Fatigue experiments on single crystal silicon in an oxygen-free environment", J. Microelectromech. Sys., Vol. 24, No. 2, April 2015
[5] Alter et al., "Characterization of accelerated fatigue in thick epi-polysilicon vacuum encapsulated MEMS resonators", J. Microelectromech. Sys., Vol. 29, No. 6, December 2020
[6] Alter et al., "First fatigue measurements on thick epi-polysilicon MEMS in ultraclean environment ", Solid-State Sensors, Actuators and Microsystems Workshop, Hilton Head Island, South Carolina, USA, 3-7 June 2018
[7] Hatty et al., "Fracture toughness, fracture strength and stress corrosion cracking of Silicon Dioxide thin films", J. Microelectromech. Sys, Vol. 17, No. 4, 2008
[8] Tsuchiya et al., "Tensile testing of insulating thin films; humidity effect on tensile strength of SiO2 films", Sensors and Actuators 82 (2000)
[9] Fujiyoshi et al., "Improved anchor design for flat MEMS structure by suppressing deformation due to buried-oxide stress on silicon-on-insulator wafer", J. Micromech. Microeng. 31 (2021) 045001
[10] Renaud et al., "Improved mechanical reliability of MEMS piezoelectric vibration energy harvesters for automotive applications", Proc. MEMS, San Francisco, CA, USA, 26-30 Jan. 2014
[11] Yokota et al., "Thickness control of cantilever beam for robust and high-power MEMS energy harvester", Proc. PowerMEMS, Salt Lake City, Utah, USA, 12-15 Dec. 2022
[12] Ngo et al., "Corner rounding to strengthen silicon pressure sensors using DRIE", Proc. SENSORS, Lecce, Italy, 26-29 Oct. 2008
[13] Mescheder et al., "Corner rounding of sharp silicon punching tool edges by local oxidation of silicon ", Microelectronic Engineering 141 (2015)
[14] Shimizu et al., "Mechanism and control technology of trench corner rounding by Hydrogen annealing for highly reliable trench MOSFET", Proc. International Symposium on Power Semiconductor Devices and IC's, Naples, Italy, 4-8 June 2006
[15] Park et al.," Low-temperature smoothing method of scalloped DRIE trench by post-dry etching process based on SF6 plasma", Micro and Nano Syst Lett (2020) 8:14
[16] Bertini et al., "Scalloping and stress concentration in DRIE-manufactured comb drives", MDPI Actuators 2018, 7, 57
[17] Mohammed et al., "Smoothening of scalloped DRIE trench walls", Materials Science in Semiconductor Processing 63 (2017) 83-89

## Patentansprüche

1. Verfahren (100) zum Herstellen eines Mikrostrukturelements, mit folgenden Schritten:
Bereitstellen (110) eines Substrats,
Anordnen (120) einer Vertiefungsstruktur in einem ersten Hauptoberflächenbereich des Substrats,
Anordnen (130) einer Abdeckungsschicht auf dem ersten Hauptoberflächenbereich und in der Vertiefungsstruktur des Substrats,
Aufbringen (140) einer Funktionsschicht auf der Abdeckungsschicht auf dem ersten Hauptoberflächenbereich und in der Vertiefungsstruktur des Substrats;
Planarisieren (150) der Funktionsschicht, um einen planaren ersten Hauptoberflächenbereich der Funktionsschicht zu erhalten, wobei sich die Funktionsschicht an deren gegenüberliegenden zweiten Hauptoberflächenbereich entlang des Substrats und ferner in die Vertiefungsstruktur des Substrats erstreckt und in der Vertiefungsstruktur eine Verstärkungsstruktur bildet; und
Freilegen (160) eines beweglichen Funktionsbereichs der Funktionsschicht zumindest durch bereichsweises Entfernen des Substrats unterhalb des beweglichen Funktionsbereichs, wobei die Verstärkungsstruktur zumindest teilweise in einem Verankerungsbereich der Funktionsschicht an dem Substrat angeordnet ist, und wobei die Funktionsschicht ohne Verstärkungsstruktur eine erste Dicke d1 und die Funktionsschicht mit der Verstärkungsstruktur eine größere zweite Dicke d2, mit d2 > d1, aufweist.

2. Verfahren (100) nach Anspruch 1, wobei die Vertiefungsstruktur mit einer solchen Tiefe in dem Substrat angeordnet und die Funktionsschicht mit einer solchen Dicke auf das Substrat aufgebracht wird, dass nach dem Planarisieren die Verstärkungsstruktur der Funktionsschicht in dem Verankerungsbereich eine größere zweite Dicke d2, mit d2 ≥ 2*d1, aufweist.

3. Verfahren (100) nach einem der vorhergehenden Ansprüche, wobei die Vertiefungsstruktur mit einer solchen Tiefe in dem Substrat angeordnet und die Funktionsschicht mit einer solchen Dicke auf das Substrat aufgebracht wird, dass nach dem Planarisieren die erste Dicke d1 der Funktionsschicht zwischen 2 und 125 µm oder zwischen 3 und 80 µm und die zweite Dicke d2 der Verstärkungsstruktur, mit d2 ≥ 2*d1, zwischen 4 und 250 µm oder zwischen 6 und 160 µm liegt.

4. Verfahren (100) nach einem der vorhergehenden Ansprüche, wobei bei dem Schritt des Freilegens eines beweglichen Funktionsbereichs der Funktionsschicht ferner die Abdeckungsschicht (vertikal) unterhalb des beweglichen Funktionsbereichs zumindest bereichsweise entfernt wird.

5. Verfahren (100) nach einem der vorhergehenden Ansprüche,
wobei die Verstärkungsstruktur als ein einteiliges Verstärkungselement an dem zweiten Hauptoberflächenbereich der Funktionsschicht angeordnet wird,
oder
wobei die Verstärkungsstruktur mit einer Mehrzahl von Verstärkungselementen an dem zweiten Hauptoberflächenbereich der Funktionsschicht angeordnet wird, wobei optional die Vertiefungselemente der Vertiefungsstruktur mit einer Mehrzahl von Vertiefungselementen mit einer maximalen Vertiefungsbreite in dem ersten Hauptoberflächenbereich des Substrats angeordnet werden, und wobei optional die Funktionsschicht mit einer Schichtdicke aufgebracht wird, die zumindest der halben maximalen Vertiefungsbreite der Vertiefungselemente entspricht.

6. Verfahren (100) nach einem der vorhergehenden Ansprüche, ferner mit folgendem Schritt:
Durchführen (125) eines Verrundungsprozesses von Kantenbereichen an dem ersten Hauptoberflächenbereich des mit der zumindest einen Vertiefung versehenen Substrats, um an den Kantenbereichen Rundungsradien zwischen 0,5 µm und 9 µm, zwischen 1 und 7 µm oder zwischen 1,5 µm und 5 µm vorzusehen,
wobei optional der Verrundungsprozess mit einem Trockenätzprozess, Naßätzprozess, Oxidationsprozess oder Temperungsprozess in Wasserstoff durchgeführt wird.

7. Verfahren (100) nach einem der vorhergehenden Ansprüche, wobei der Schritt des Freilegens des beweglichen Funktionsbereichs der Funktionsschicht ausgehend von dem zweiten Hauptoberflächenbereich mittels eines anisotropen Ätzprozesses durchgeführt wird.

8. Verfahren (100) nach einem der vorhergehenden Ansprüche, wobei das Substrat ein Siliziummaterial, die Funktionsschicht ein Poly-Si-Material und die Abdeckungsschicht ein Oxidmaterial aufweist.

9. Verfahren (100) nach einem der vorhergehenden Ansprüche, wobei das Mikrostrukturelement als ein auslenkbares Bauelement ausgebildet wird.

10. Verfahren (100) nach einem der vorhergehenden Ansprüche,
wobei bei dem Schritt (120) des Anordnens einer Vertiefungsstruktur (22; 22, 23) eine erste Vertiefungsstruktur (22) mit zumindest einer ersten Vertiefung (22-#) in dem ersten Hauptoberflächenbereich (20-A) des Substrats (20) angeordnet wird (122), und eine zweite Vertiefungsstruktur (23) mit zumindest einer zweiten Vertiefung (23-#) im Bereich bzw. ausgehend von der ersten Vertiefungsstruktur (22) in dem Substrat (20) angeordnet wird (124),
wobei bei dem Schritt (130) die Abdeckungsschicht (50) auf dem ersten Hauptoberflächenbereich (20-A) und in der ersten und zweiten Vertiefungsstruktur (22, 23) des Substrats (20) angeordnet wird,
wobei bei dem Schritt (140) die Funktionsschicht (30) auf der Abdeckungsschicht (50) auf dem ersten Hauptoberflächenbereich (20-A) und in der ersten und zweiten Vertiefungsstruktur (22, 23) des Substrats (20) aufgebracht wird; und
wobei bei dem Schritt (150) die Funktionsschicht (30) bis zu (der Ebene) der Abdeckungsschicht (50) auf dem ersten Hauptoberflächenbereich (20-A) des Substrats (20) planarisiert wird, um einen planaren ersten Hauptoberflächenbereich (30-A) der Funktionsschicht (30) zu erhalten, wobei sich die Funktionsschicht (30) an deren gegenüberliegenden zweiten Hauptoberflächenbereich (30-B) entlang des Substrats (20) und ferner in die erste und zweite Vertiefungsstruktur (22, 23) des Substrats (20) erstreckt und in der zweiten Vertiefungsstruktur (23) die Verstärkungsstruktur (40, 42) bildet.

11. Mikrostrukturelement (10), mit folgenden Merkmalen:
ein mit einer Ausnehmung (26) versehenes Substrat (20), und
einer Funktionsschicht (30), die mit einem beweglichen Funktionsbereich (30-1) die Ausnehmung (26) in dem Substrat (20) überspannt und einen planaren ersten Hauptoberflächenbereich (30-A) aufweist, wobei ein zweiter gegenüberliegender Hauptoberflächenbereich (30-B) der Funktionsschicht (30) an einem Randbereich (30-2) mit dem Substrat (20) gekoppelt ist, und wobei die Funktionsschicht (30) an deren zweiten Hauptoberflächenbereich (30-B) mindestens eine mit der Funktionsschicht direkt verbundene oder einstückig ausgebildete Verstärkungsstruktur (40) aufweist,
wobei die mindestens eine Verstärkungsstruktur (40, 42) zumindest teilweise in einem Verankerungsbereich (30-2) der Funktionsschicht (30) an dem Substrat (20) angeordnet ist, und wobei die Funktionsschicht (30) in dem beweglichen Funktionsbereich (30-1) ohne Verstärkungsstruktur eine erste Dicke d1 und die Funktionsschicht (30) mit der Verstärkungsstruktur in dem Verankerungsbereich eine größere zweite Dicke d2, mit d2 > d1, aufweist.

12. Mikrostrukturelement (10) nach Anspruch 11, wobei die Verstärkungsstruktur (40) der Funktionsschicht (30) in dem Verankerungsbereich die größere zweite Dicke d2, mit d2 ≥ 2*d1, aufweist.

13. Mikrostrukturelement (10) nach Anspruch 11 oder 12,
wobei die Verstärkungsstruktur (40) als ein einteiliges Verstärkungselement angeordnet ist,
oder
wobei die Verstärkungsstruktur (40) eine Mehrzahl von Verstärkungselementen (40-1, ..., 40-n) aufweist, die an dem zweiten Hauptoberflächenbereich (30-B) der Funktionsschicht (30) angeordnet sind.

14. Mikrostrukturelement (10) nach einem der Ansprüche 11 bis 13, wobei die erste Dicke d1 der Funktionsschicht (30) zwischen 2 und 125 µm oder zwischen 3 und 80 µm und die zweite Dicke d2 der Funktionsschicht (30) mit der Verstärkungsstruktur (40), mit d2 ≥ 2*d1, zwischen 4 und 250 µm oder zwischen 6 und 160 µm liegt.

15. Mikrostrukturelement (10) nach einem der Ansprüche 11 bis 14, wobei Kantenbereiche (44) an dem beweglichen Bereich (30-1) der Funktionsschicht (30) abgerundet sind und Rundungsradien zwischen 0,5 µm und 9 µm, zwischen 1 und 7 µm oder zwischen 1,5 und 5 µm aufweisen.

16. Mikrostrukturelement (10) nach einem der Ansprüche 11 bis 15, wobei das Substrat (20) ein Siliziummaterial, die Funktionsschicht (30) ein Poly-Si-Material und eine Abdeckungsschicht (50) zwischen dem Substrat (20) und der Funktionsschicht (30) ein Oxidmaterial aufweist.

17. Mikrostrukturelement (10) nach einem der Ansprüche 11 bis 16, wobei das Mikrostrukturelement (10) als ein auslenkbares Bauelement ausgebildet ist.
